# EUROPÄISCHE PATENTANMELDUNG

(11) **EP 0 977 266 A1**
(43) Veröffentlichungstag der Anmeldung: **02.02.2000**
(21) Anmeldenummer: 99110842.4
(22) Anmeldetag: 02.06.1999
(51) Int. Cl.: H01L 27/108, H01L 21/8242

(54) **Grabenkondensator mit Isolationskragen und entsprechendes Herstellungsverfahren**

(30) Priorität: 15.06.1998 EP 98110933
(71) Anmelder: SIEMENS AKTIENGESELLSCHAFT, 80333 München (DE)
(72) Erfinder: Wurster, Kai, 01099 Dresden (DE); Schrems, Martin Dr., 01465 Langebrück (DE); Faul, Jürgen Dr., 01445 Radebeul (DE); Morhard, Klaus-Dieter, Dr., 01099 Dresden (DE); Lamprecht, Alexandra, 01099 Dresden (DE); Dequiedt, Odile, 01097 Dresden (DE)

(57) **Zusammenfassung**

Die vorliegende Erfindung schafft einen Grabenkondensator (160), der in einer Speicherzelle (100) verwendet werden kann. Der Grabenkondensator (160) ist in einem Substrat (101) gebildet und besteht aus einem Graben (108) mit einem oberen Bereich (109) und einem unteren Bereich (111); einem Isolationskragen (168), der in dem oberen Bereich (109) des Grabens (108) gebildet ist; einer vergrabenen Wanne (170), die von dem unteren Bereich (111) des Grabens (108) durchsetzt ist; einer vergrabenen Platte (165), als äußere Kondensatorelektrode, die um den unteren Bereich (111) des Grabens (108) gebildet ist; einer dielektrischen Schicht (164), als Kondensatordielektrikum, zur Verkleidung des unteren Bereichs (111) des Grabens (108) und des Isolationskragens (168); einer leitenden Grabenfüllung (161), welche in den Graben (108) gefüllt ist und die innere Kondensatorelektrode bildet; einem vergrabenen Kontakt (250), der in dem Substrat (101) gebildet ist; wobei der vergrabene Kontakt (250) durch Implantation, Plasmadotierung und/oder Gasphasendotierung eingebracht wurde. Vorzugsweise wird an der Grenzfläche (201) des vergrabenen Kontakts (250) eine Tunnelschicht (205), z. B. aus Oxid-, Nitrid- oder Oxynitrid gebildet.

## Beschreibung

Die vorliegende Erfindung betrifft einen Grabenkondensator mit einem Isolationskragen und ein entsprechendes Herstellungsverfahren.

Obwohl auf beliebige Grabenkondensatoren anwendbar, werden die vorliegende Erfindung und die ihr zugrundeliegende Problematik nachstehend in Bezug auf einen in einer DRAM-Speicherzelle verwendeten Grabenkondensator erläutert. Solche Speicherzellen werden in integrierten Schaltungen (ICs), wie beispielsweise Speichern mit wahlfreiem Zugriff (RAMs), dynamischen RAMs (DRAMs), synchronen DRAMs (SDRAMs), statischen RAMs (SRAMs) und Nur-Lese-Speichern (ROMs) verwendet. Andere integrierte Schaltungen enthalten Logikvorrichtungen, wie z.B. programmierbare Logikarrays (PLAs), anwenderspezifische ICs (ASICs), Mischlogik/ Speicher-ICs (eingebettete DRAMs) oder sonstige Schaltungsvorrichtungen. Üblicherweise wird eine Vielzahl von ICs auf einem Halbleitersubstrat, wie z.B. einem Siliziumwafer, parallel hergestellt. Nach der Verarbeitung wird der Wafer zerteilt, um die ICs in eine Vielzahl individueller Chips zu separieren. Die Chips werden dann in Endprodukte verpackt, beispielsweise zur Verwendung in Verbraucherprodukten, wie z.B. Computersystemen, zellulären Telefonen, persönlichen digitalen Assistenten (PDAs) und weiteren Produkten. Zu Diskussionszwecken wird die Erfindung hinsichtlich der Bildung einer einzelnen Speicherzelle beschrieben.

Integrierte Schaltungen (ICs) oder Chips verwenden Kondensatoren zum Zwecke der Ladungsspeicherung. Ein Beispiel eines IC, welcher Kondensatoren zum Speichern von Ladungen verwendet, ist ein Speicher-IC, wie z.B. ein Chip für einen dynamischen Schreib-/Lesespeicher mit wahlfreiem Zugriff (DRAM). Der Ladungszustand ("0" oder "1") in dem Kondensator repräsentiert dabei ein Datenbit.

Ein DRAM-Chip enthält eine Matrix von Speicherzellen, welche in Form von Zeilen und Spalten verschaltet sind. Üblicherweise werden die Zeilenverbindungen als Wortleitungen und die Spaltenverbindungen als Bitleitungen bezeichnet. Das Auslesen von Daten von den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Transistor. Der Transistor enthält zwei Diffusionsbereiche, welche durch einen Kanal getrennt sind. Oberhalb des Kanals ist ein Gate angeordnet. Abhängig von der Richtung des Stromflusses bezeichnet man den einen Diffusionsbereich als Drain und den anderen als Source. Die Gates sind mit einer Wortleitung verbunden, das Drain-Gebiet ist mit einer Bitleitung verbunden. Das Source-Gebiet ist mit dem Kondensator verbunden. Das Anlegen einer geeigneten Spannung an das Gate schaltet den Transistor ein, ermöglicht einen Stromfluß zwischen dem Source-Gebiet und dem Drain-Gebiet durch den Kanal, um so eine Verbindung zwischen dem Kondensator und der Bitleitung zu bilden. Das Ausschalten des Transistors trennt diese Verbindung, indem der Stromfluß durch den Kanal unterbrochen wird.

Die in dem Kondensator gespeicherte Ladung baut sich mit der Zeit aufgrund eines inhärenten Leckstroms ab. Bevor sich die Ladung auf einen unbestimmten Pegel (unterhalb eines Schwellwerts) abgebaut hat, muß der Speicherkondensator aufgefrischt werden.

Das fortlaufende Bestreben nach Verkleinerung der Speichervorrichtungen fördert den Entwurf von DRAMs mit größerer Dichte und kleinerer charakteristischer Größe, d.h. kleinerer Speicherzellenfläche. Zur Herstellung von Speicherzellen, welche eine geringeren Oberflächenbereich besetzen, werden kleinere Komponenten, beispielsweise Kondensatoren, verwendet. Jedoch resultiert die Verwendung kleinerer Kondensatoren in einer erniedrigten Speicherkapazität, was wiederum die Funktionstüchtigkeit und Verwendbarkeit der Speichervorrichtung widrig beeinflussen kann. Beispielsweise erfordern Leseverstärker einen ausreichenden Signalpegel zum zuverlässigen Auslesen der Information in den Speicherzellen. Das Verhältnis der Speicherkapazität zur Bitleitungskapazität ist entscheidend bei der Bestimmung des Signalpegels. Falls die Speicherkapazität zu gering ist, kann dieses Verhältnis zu klein zur Erzeugung eines hinreichenden Signals sein. Ebenfalls erfordert eine geringere Speicherkapazität eine höhere Auffrischfrequenz.

Ein Kondensatortyp, welcher üblicherweise in DRAMs verwendet wird, ist ein Grabenkondensator. Ein Grabenkondensator hat eine dreidimensionale Struktur, welche in dem Siliziumsubstrat ausgebildet ist. Eine Erhöhung des Volumens bzw. der Kapazität des Grabenkondensators kann durch tieferes Ätzen in das Substrat erreicht werden. In diesem Fall bewirkt die Steigerung der Kapazität des Grabenkondensators keine Vergrößerung der von der Speicherzelle belegte Oberfläche.

Ein üblicher Grabenkondensator enthält einen in das Substrat geätzten Graben. Dieser Graben wird typischerweise mit n⁺-dotiertem Polysilizium gefüllt, welches als innere Kondensatorelektrode dient (auch als Speicherelektrode bezeichnet). Üblicherweise wird eine äußere Kondensatorelektrode (auch als "vergrabene Platte" bezeichnet) durch Ausdiffundieren von n⁺-Dotierstoffen von einer Dotierstoffquelle in einen Bereich des Substrats, welcher den unteren Bereich des Grabens umgibt, gebildet. Ein n⁺-dotiertes Silikatglas, wie z.B. ein mit Arsen dotiertes Silikatglas (ASG), dient dabei als die Dotierstoffquelle. Ein Speicherdielektrikum, welches Nitrid enthält, wird üblicherweise zur Isolation der beiden Kondensatorelektroden verwendet.

In dem oberen Bereich des Grabens wird ein dielektrischer Kragen erzeugt, um einen Leckstrom zwischen dem Kondensatoranschluß und der vergrabenen Platte zu verhindern. Das Speicherdielektrikum in dem oberen Bereich des Grabens, wo der Isolationskragen zu bilden ist, wird vor dessen Bildung entfernt. Die Entfernung des Speicherdielektrikums, welches beispielsweise aus Nitrid besteht, verhindert einen vertikalen Leckstrom entlang des Isolationskragens.

Jedoch schafft die Entfernung des oberen Bereichs des Speicherdielektrikums Pinholes bzw. Nadellöcher am Übergang zwischen dem unteren Teil des Isolationskragens und dem oberen Teil des Speicherdielektrikums. Solche Pinholes verschlechtern die Qualität des Speicherdielektrikums und sind eine wesentliche Quelle für den Ladungsabbau aus dem Grabenkondensator. Dies reduziert die Haltezeit des Grabenkondensators und beeinträchtigt somit seine Funktionstüchtigkeit.

Zur Verhinderung der Bildung von Pinholes wurde ein zweistufiger Grabenätzprozeß vorgeschlagen. Dabei wird zunächst der Graben teilweise durch reaktives Ionenätzen (RIE) bis zur Tiefe des Isolationskragens geätzt. Das reaktive Ionenätzen ist selektiv bezüglich der verwendeten Ätz-Hartmaske. Die üblicherweise für das reaktive Ionenätzen verwendeten Chemikalien umfassen beispielsweise NF₃/HBr/He/O₂. Eine Oxidschicht wird anschließend abgeschieden und derart geätzt, daß sie den Isolationskragen auf den Grabenseitenwänden bildet. Die reaktive Ionenätzung ist hinsichtlich Silizium selektiv, wenn beispielsweise die Chemikalien CHF₃/He/O₂, CHF₃/Ar, C₄F₈/Ar oder CF₄ verwendet werden. Der übrige Bereich des Grabens wird nach der Isolationskragenbildung geätzt. Das Speicherdielektrikum wird dann über dem Isolationskragen und dem unteren Bereich der Grabenseitenwände gebildet. Dieses Verfahren eliminiert die Notwendigkeit der Beseitigung des oberen Bereichs des Speicherdielektrikums und somit die Bildung von Pinholes.

Obwohl solch eine zweistufige Grabenbildung hilfreich für die Verhinderung von Pinholes ist, kann der zweite reaktive Ionenätzschritt zum Entfernen von Silizium eine übermäßige Erosion des Isolationskragens verursachen. Solch eine Verschlechterung des Isolationskragens bewirkt das Auftreten von Leckströmen. Weiterhin dient der Isolationskragen als eine Ätz-Hartmaske für den zweiten reaktiven Ionenätzschritt zur Herstellung des Grabens, welcher einen unteren Bereich des Grabens mit einem Durchmesser schafft, der gleich dem Innendurchmesser des Kragens ist. Somit ist der untere Bereich des Grabens kleiner als der obere Bereich, welcher einen Durchmesser aufweist, der etwa gleich dem Außendurchmesser des Kragens ist. Dies ist unerwünscht, da hierdurch die Kapazität des Kondensators reduziert ist.

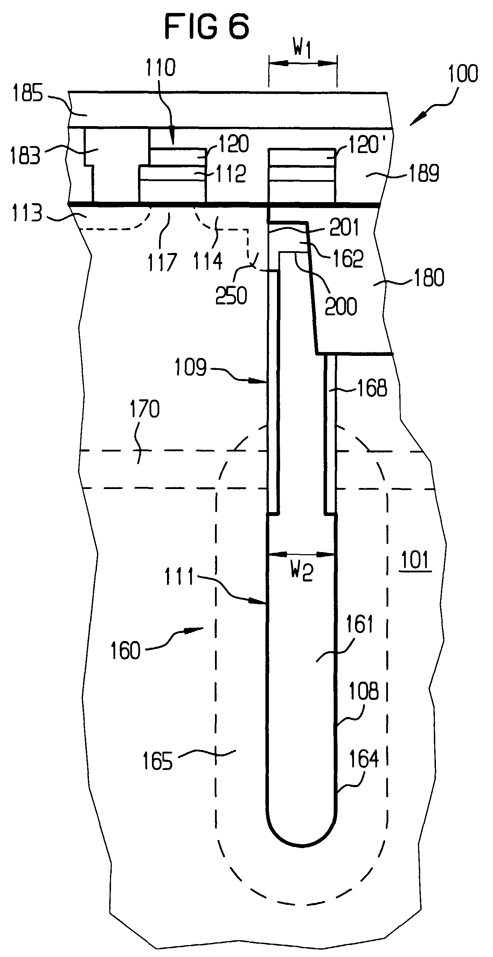

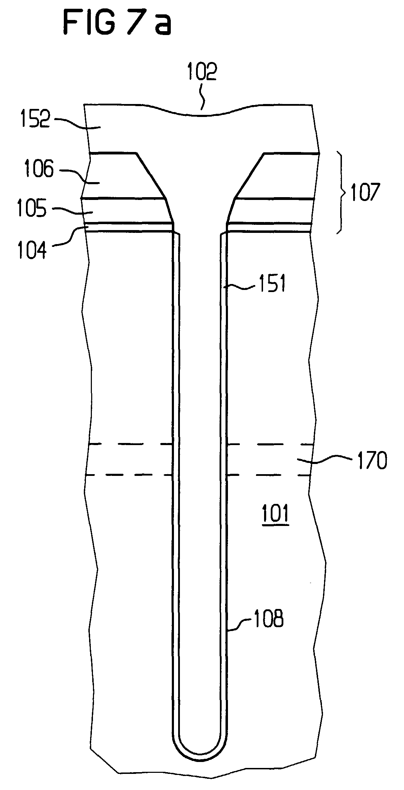

Mit Bezug auf Fig. 6 wird nun eine übliche DRAM-Speicherzelle und mit Bezug auf Fig. 7a-g eine Variante des Verfahrens zur Herstellung der DRAM-Speicherzelle nach Fig. 6 beschrieben.

Der Grabenkondensator nach Fig. 6 enthält eine dielektrische Schicht 164, die als Speicherdielektrikum eines Grabenkondensators 160 dient und stufenförmig über einem Isolationskragen 168 gebildet ist, was die Notwendigkeit der Entfernung des oberen Bereichs der dielektrischen Schicht 164, die sich auf dem Isolationskragen 168 befindet, eliminiert. Dies vermeidet die Bildung von Nadellöchern am Übergang des Isolationskragens 168 und des oberen Randes der dielektrischen Schicht 164. Zusätzlich hat ein unterer Bereich 111 des Grabens 108 eine Breite bzw. einen Durchmesser W₂, der zumindest gleich groß ist wie die Breite bzw. der Durchmesser W₁ eines oberen Bereichs 109. Demgemäß lassen sich reduzierte Leckströme und eine erhöhte Kapazität erzielen.

Fig. 6 zeigt den Grabenkondensator 160, der in einer DRAM-Speicherzelle 100 implementiert ist. Ohne Beschränkung der Allgemeinheit ist die DRAM-Speicherzelle 100 eine MINT-Zelle (MINT = merged isolation node trench) mit einer leitenden vergrabenen Brücke 162 (Buried Strap). Andere Zellkonfigurationen, wie z.B. diejenigen, die eine an der Oberfläche liegende Brücke aufweisen, sind ebenfalls verwendbar. Die typischen Dimensionen eines Grabens 108, welcher beispielsweise in einem 256 Mb-DRAM-Chip unter Verwendung von 0,25 µm-Designregeln implementiert ist, betragen etwa 7-8 µm Tiefe, und zwar mit einer Grabenöffnung von etwa 0,25 µm mal 0,50 µm.

Wie in Fig. 6 gezeigt, ist der Grabenkondensator 160 in einem Substrat 101 gebildet. Das Substrat 101 ist beispielsweise mit Dotierstoffen eines ersten Leitungstyps leicht dotiert. Bei dieser Variante ist das Substrat 101 leicht mit p-Typ-Dotierstoffen (p⁻), wie z.B. B, dotiert. Die Verwendung eines stark dotierten p-Typ-Substrats (p⁺) ist ebenfalls möglich. Beispielsweise können epitaktisch hergestellte p⁺/p⁻-Substrate verwendet werden. Solche Substrate haben eine Dotierstoffkonzentration von etwa 10¹⁹ cm⁻³ mit einer p⁻-Epitaxieschicht von typischerweise 2-3 µm Dicke. Die Konzentration von Bor beträgt etwa 1,5 x 10¹⁶ cm⁻³. Eine (nicht gezeigte) p-Typ-Wanne ist zur Isolierung benachbarter Speicherzellen vorgesehen. Die Dotierstoffkonzentration der p-Wannen beträgt etwa 5 x 10¹⁷ bis 8 x 10¹⁷ cm⁻³.

Bei dieser Variante hat im Gegensatz zu den oben erwähnten üblichen Grabenkondensator 160, welcher durch das zweistufige Grabenätzverfahren hergestellt wird, der untere Bereich 111 des Grabens 108 eine Breite bzw. einen Durchmesser W₂, welcher im wesentlichen gleich wie oder größer als die Breite bzw. der Durchmesser W₁ des oberen Bereichs 109 ist. Eine vergrabene Platte 165 umgibt den unteren Bereich 109 des Grabens 108. Wie gezeigt, überlappt die vergrabene Platte 165 teilweise mit dem oberen Bereich 109 des Grabens 108. Die vergrabene Platte 165 dient als äußere Kondensatorelektrode. In dem Graben ist 108 eine leitende Grabenfüllung 161 als innere Kondensatorelektrode angeordnet. Bei der leitenden Grabenfüllung 161 handelt es sich Typischerweise um mit einem Dotierstoff eines zweiten Leitungstyps datiertes Polysilizium. Beispielsweise ist die leitende Grabenfüllung 161 stark datiert mit n-Typ-Dotierstoffen (n⁺), wie z.B. As oder P. Bei einer Variante ist die leitende Grabenfüllung 161 stark mit As dotiert. Die Konzentration von As beträgt etwa 10¹⁹ bis 10²⁰ cm⁻³.

Die dielektrische Schicht 164 trennt die Kondensatorelektroden. Bei dieser Variante verkleidet die dielektrische Schicht 164 die inneren Seitenwände des Isolationskragens 168 und die Seitenwände im unteren Bereich 111 des Grabens 108. Die dielektrischen Schicht 164 besteht beispielsweise aus Nitrid oder Nitrid/Oxid. Oxid/Nitrid/Oxid oder eine sonstige dielektrische Schicht oder ein Stapel von dielektrischen Schichten, wie z.B. Oxid, nitridiertes Oxid oder NONO, sind ebenfalls verwendbar.

Die Verbindung der vergrabenen Platte 165 des Kondensators mit anderen Kondensatoren innerhalb des DRAMs wird über eine vergrabene Wanne 170 bewerkstelligt, welche Dotierstoffe des zweiten Leitungstyps aufweist. Bei der vorliegenden Variante ist die vergrabene Wanne 170 durch Implantation von n-Typ-Dotierstoffen, wie z.B. As oder P, gebildet. Die Konzentration der vergrabenen Wanne 170 beträgt etwa 1x10¹⁷ - 1x10²⁰ cm⁻³. Die vergrabene Wanne 170 kann ebenfalls aus einer n-Typ-Epitaxieschicht gebildet werden und mit einer Referenzspannung verbunden werden. Durch Verbinden der vergrabenen Platten 165 der Kondensatoren in dem DRAM mit einer gemeinsamen Referenzspannung wird das maximale elektrische Feld in der dielektrischen Schicht 164 minimiert, was die Zuverlässigkeit verbessert. Bei dieser Variante liegt die Referenzspannung in der Mitte zwischen der niedrigsten und der höchsten Spannung der Bitleitung, was üblicherweise der Hälfte der Versorgungsspannung oder V_{DD}/2 entspricht. Andere Referenzspannungen, wie z.B. Massepotential, sind ebenfalls verwendbar.

Die leitende vergrabene Brücke 162 ist oberhalb der leitenden Grabenfüllung 161 vorgesehen. Die Dotierstoffe von der leitenden Grabenfüllung 161 diffundieren in das Substrat 101 aus, um einen vergrabenen Kontakt 250 und damit den Kondensatoranschluß zu bilden, welcher einen Transistor 110 mit dem Grabenkondensator 160 verbindet.

Der Isolationskragen 168 ist im oberen Bereich des Grabens 108 gebildet und verläuft bis zur Oberseite der vergrabenen Platte 165. Wie gezeigt, ist der Isolationskragen 168 leicht unter die Oberfläche des Substrats 101 zurückgezogen, um die leitende vergrabene Brücke 162 aufzunehmen. Der Isolationskragen 168 ist aus einem dielektrischen Material hergestellt. Bei der vorliegenden Variante wird zunächst eine thermische Oxidschicht gebildet und darauf eine TEOS-Schicht abgeschieden. Der Isolationskragen 168 verhindert oder reduziert den Leckstrom von der leitenden vergrabenen Brücke 162 zu der vergrabenen Platte 165. Bei einer Variante ist der Kragen etwa 1,2 µm tief und 20 bis 90 nm dick.

Eine Grabenisolierung 180 ist in dem oberen Bereich 109 des Grabens 108 zur Isolierung der DRAM-Speicherzelle von anderen Zellen in der Matrix und zum Verhindern einer Brückenbildung zwischen benachbarten Kondensatoren vorgesehen. Wie gezeigt, überlappt die Grabenisolierung 180 einen Bereich des Grabens 108 und läßt einen übrigen Bereich offen, so daß ein Stromfluß zwischen dem Transistor 110 und zwischen dem Grabenkondensator 160 möglich ist. Bei der vorliegenden Variante überlappt die Grabenisolierung 180 nominell etwa die Hälfte der Grabenbreite. Die Grabenisolierung verhindert oder reduziert den Leckstrom von der leitenden Brücke 162 zu den benachbarten leitenden Brücken. Die Tiefe der Grabenisolierung beträgt etwa 0,25 µm.

Diese Variante weist eine Grenzfläche 201 zwischen der leitenden vergrabenen Brücken 162 und dem Substrat 101 auf, sowie eine zusätzliche Grenzfläche 200 zwischen leitender Grabenfüllung 161 und leitender vergrabener Brücke 162, worauf bei einer später beschriebenen Variante nochmals detaillierter eingegangen wird.

Der Transistor 110 besteht aus einem Gate 112, einem Drain-Gebiet 113 und einem Source-Gebiet 114. Das Drain-Gebiet 113 und das Source-Gebiet 114 weisen n-Typ-Dotierstoffe, wie z.B. As oder P auf. Das Source-Gebiet 114 ist mit dem vergrabenen Kontakt 250 verbunden. Das Gate 112, welches an die Wortleitung 120 angeschlossen ist, besteht aus einer Polysiliziumschicht. Typischerweise ist das Polysilizium mit n- oder p-Typ-Dotierstoffen dotiert. Optionellerweise ist eine Metallsilizidschicht (nicht gezeigt) über der Polysiliziumschicht gebildet, um den Schichtwiderstand des Gate 112 zu reduzieren. Das Polysilizium und das Silizid werden oft als "Polycid(e)" bezeichnet.

Das Gate 112 wird mit einer Nitridschicht bedeckt, welche als Ätzmaske zum Isolieren der Wortleitung verwendet wird. Zusätzlich werden ein Seitenwandoxid (nicht gezeigt) und eine Verkleidung verwendet, um die Wortleitung 120 zu isolieren. Die Verkleidung umfaßt beispielsweise Nitrid oder ein anderes geeignetes Material. Die Verkleidung dient ebenfalls als Ätzstopp während der Bildung eines randlosen Kontaktes 183. Der randlose Kontakt bildet eine Verbindung zwischen dem Drain-Gebiet 113 und einer Bitleitung 185. Eine Isolationsschicht 189, welche beispielsweise aus BPSG oder einem anderen dielektrischen Material, wie z.B. einem Oxid besteht, isoliert die Bitleitung 185 von dem Drain-Gebiet 113 und dem Source-Gebiet 114.

Eine passierende Wortleitung 120' ist oberhalb der Grabenisolierung 180 gebildet. Die passierende Wortleitung 120' ist von dem Graben 108 durch die Grabenisolierung 180 und ein dickes Deckoxid isoliert. Bei der vorliegenden Variante sind die Ränder der vorbeilaufenden Wortleitung im wesentlichen mit den Grabenseitenwänden ausgerichtet. Solche Konfiguration wird als gefaltete Bitleitungsarchitektur bezeichnet. Andere Konfigurationen, wie z.B. eine offene oder eine offene/gefaltete Struktur, sind ebenfalls anwendbar.

Wie beschrieben, ist der erste Leitungstyp der p-Typ und der zweite Leitungstyp der n-Typ. Die Erfindung ist ebenfalls auf Grabenkondensatoren anwendbar, welche p-Typ-Polysilizium in einem n-Typ-Substrat gebildet haben. Weiterhin ist es möglich, daß Substrat 101, die Wanne 170, die vergrabene Platte 165 und die anderen Elemente der DRAM-Speicherzelle mit Verunreinigungsatomen stark oder leicht zu dotieren, um die jeweils gewünschten elektrischen Charakteristika zu erhalten.

Obwohl der erste elektrische Leitungstyp der p-Typ und der zweite elektrische Leitungstyp der n-Typ ist, ist die Bildung der DRAM-Speicherzelle in einem n-Typ-Substrat mit einein Graben 108, der mit p-Typ-Polysilizium gefüllt ist, ebenfalls möglich. Weiterhin ist es möglich, einen vertikalen Transistor oder andere Typen von Speicherzellen-Layouts zu verwenden.

Fig. 7a-g zeigen eine Variante des Verfahrens zur Herstellung der DRAM-Speicherzelle nach Fig. 6.

Mit Bezug auf Fig. 7a wird das Substrat 101 bereitgestellt, auf dem die DRAM-Speicherzelle herzustellen ist. Die Hauptoberfläche des Substrats 101 ist nicht kritisch, und eine beliebige geeignete Orientierung, wie z.B. (100), (110) oder (111), ist verwendbar. Bei der vorliegenden Variante ist das Substrat 101 leicht dotiert mit p-Typ-Dotierstoffen (p⁻), wie z.B. B. Die Konzentration des B beträgt etwa 1 - 2 x 10¹⁶ cm ⁻³.

Das Substrat 101 enthält die n-dotierte vergrabene Wanne 170. Die vergrabene Wanne 170 weist P oder As als Dotierstoff auf. Bei der vorliegenden Variante wird eine Maske strukturiert, um die vergrabene Wanne 170 zu definieren. n-Typ-Dotierstoffe werden dann in die vergrabene Wanne 170 des Substrats 101 implantiert. Die vergrabene Wanne 170 dient zur Isolation der p-Wanne vom Substrat 101 und bildet ebenfalls eine leitende Brücke zwischen den vergrabenen Platten 165 der Kondensatoren. Die Konzentration und Energie der Implantation betragen etwa > 1 x 10¹³ cm ⁻² bei etwa 1,5 MeV. Alternativ wird die vergrabene Wanne 170 durch Implantieren und darauffolgendes Aufwachsen einer Silizium-Epitaxieschicht oberhalb der Substratoberfläche gebildet.

Diese Technik ist beschrieben im US-Patent Nr. 5,250,829 von Bronner et al.

Ein Unterbaustapel 107 wird auf der Oberfläche des Substrats 101 gebildet. Der Unterbaustapel 107 umfaßt beispielsweise eine Unterbau-Oxidschicht 104 und eine Unterbau-Stoppschicht 105. Die Unterbau-Stoppschicht 105, welche als Politur oder Ätzstopp für folgende Prozesse dient, weist beispielsweise Nitrid auf. Oberhalb der Unterbau-Stoppschicht 105 ist eine Hartmaskenschicht 106 vorgesehen. Diese Hartmaskenschicht 106 besteht beispielsweise aus TEOS. Andere Materialien, wie z.B. BSG, sind ebenfalls als Hartmaskenschicht verwendbar. Zusätzlich kann eine Antireflexionsbeschichtung (ARC) verwendet werden, um die lithographische Auflösung zu verbessern.

Die Hartmaskenschicht 106 wird unter Verwendung üblicher photolithographischer Techniken strukturiert, um einen Bereich 102 zu definieren, in dem der Graben 108 zu bilden ist. Diese Schritte enthalten die Abscheidung einer Photolackschicht und das selektive Belichten derselben mit dem erwünschten Muster. Der Photolack wird dann entwickelt und entweder die belichteten oder die unbelichteten Bereiche werden entfernt, und zwar abhängig davon, ob ein Positivlack oder ein Negativlack verwendet wird. Die belichteten Bereiche des Unterbaustapels 107 werden dann bis zur Oberfläche des Substrats 101 geätzt. Ein reaktiver Ionenätzschritt (RIE) bildet dann den tiefen Graben 108.

Eine Isolationskragenopferschicht 152 wird anschließend über dem Wafer abgeschieden, um den Graben 108 zu füllen. Amorphes Silizium ist ebenfalls verwendbar. Weitere Materialtypen, welche eine Temperaturstabilität bis zu 1050 bis 1100°C aufweisen und selektiv gegenüber Nitrid oder Oxid entfernbar sind, sind ebenfalls verwendbar. Die Isolationskragenopferschicht 152 wird als Opferschicht bezeichnet, da sie später entfernt wird. Typischerweise wird eine natürliche Oxidschicht 151 gebildet, welche die Grabenseitenwände auskleidet, bevor der Graben mit der Isolationskragenopferschicht 152 gefüllt wird. Die natürliche Oxidschicht 151 ist typischerweise etwa 0,3-5 nm dick.

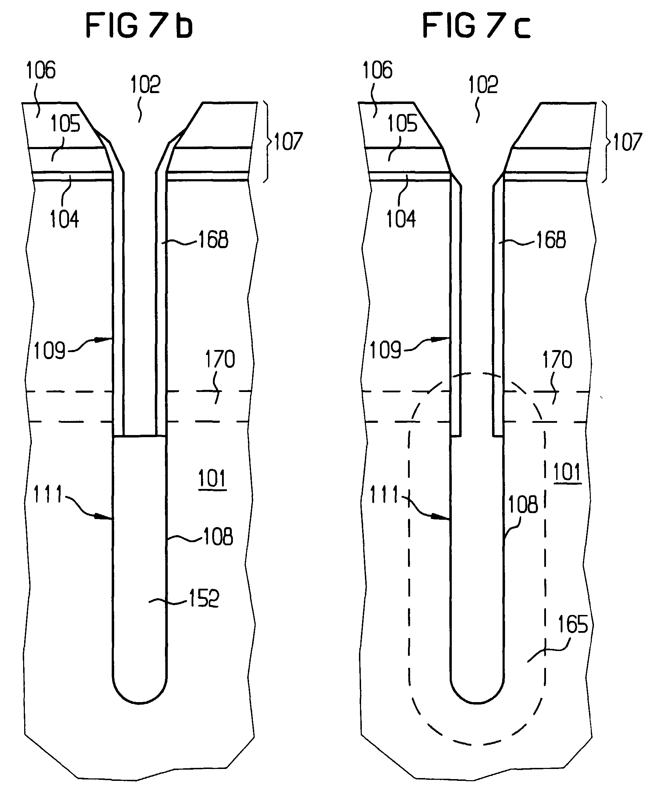

Wie in Fig. 7b gezeigt, wird die Isolationskragenopferschicht 152 dann bis zur Unterseite des zu bildenden Kragens entfernt. Das Entfernen der Isolationskragenopferschicht 152 beinhaltet beispielsweise das Planarisieren mittels chemisch-mechanischen Polierens (CMP), ein chemisches Trockenätzen (CDE) oder ein reaktives Ionenätzen zum Bilden einer koplanaren Oberfläche der Isolationskragenopferschicht 152 und der Oberfläche des Unterbaustapels 107. Ein reaktives Ionenätzen wird dann durchgeführt, um die Isolationskragenopferschicht 152 in den Graben 108 einzusenken. Die Verwendung einer chemischen Trockenätzung zum Absenken der Isolationskragenopferschicht 152 in den Graben 108 ist ebenfalls möglich. Vorzugsweise jedoch wird die Isolationskragenopferschicht 152 planarisiert und durch einen CDE- oder RIE-Schritt in einem einzelnen Schritt, typischerweise um 0,5 - 2 µm von der Substratoberfläche, eingesenkt.

Eine dielektrische Schicht wird dann über dem Wafer abgeschieden, welche den Unterbaustapel 107 und die Grabenseitenwände bedeckt. Die dielektrische Schicht wird zur Bildung des Isolationskragens 168 verwendet. Die dielektrische Schicht besteht beispielsweise aus Oxid. Bei der vorliegenden Variante wird die dielektrische Schicht durch Aufwachsen einer Schicht aus thermischem Oxid und darauffolgendem Abscheiden einer Oxidschicht durch chemische Dampfphasenabscheidung (CVD), wie z.B. plasmaunterstützte CVD (PECVD) oder Niederdruck-CVD (LPCVD), unter Verwendung von TEOS gebildet. Das CVD-Oxid kann durch einen Temperaturschritt verdichtet werden. Die Oxidschicht ist hinreichend dick, um einen vertikalen Leckstrom zu vermeiden, nämlich 10-50 nm. Alternativ kann die dielektrische Schicht eine Schicht aus thermischem Oxid aufweisen.

Bei einer anderen Variante wird die dielektrische Schicht aus CVD-Oxid gebildet. Nach der Bildung des CVD-Oxids kann ein Temperaturschritt zur Verdichtung des Oxids durchgeführt werden. Der Temperaturschritt wird beispielsweise in Ar, N₂, O₂, H₂O, N₂O, NO oder NH₃-Atmosphäre durchgeführt. Eine oxidierende Atmosphäre, wie z.B. O₂ oder H₂O kann zur Bildung einer thermischen Oxidschicht unter dem CVD-Oxid verwendet werden. Sauerstoff aus der Atmosphäre diffundiert dann durch das CVD-Oxid zum Bilden einer thermischen Oxidschicht an der Grenzfläche zum Substrat. Dies ermöglicht vorteilhafterweise die Bildung eines thermischen Oxids, falls erwünscht, ohne das Bedürfnis eines thermischen Oxidationsschritts vor der Abscheidung des CVD-Oxids. Typischerweise wird der Temperaturschritt bei einer Temperatur von etwa 1000-1100°C und etwa 0,5-3 Stunden lang durchgeführt.

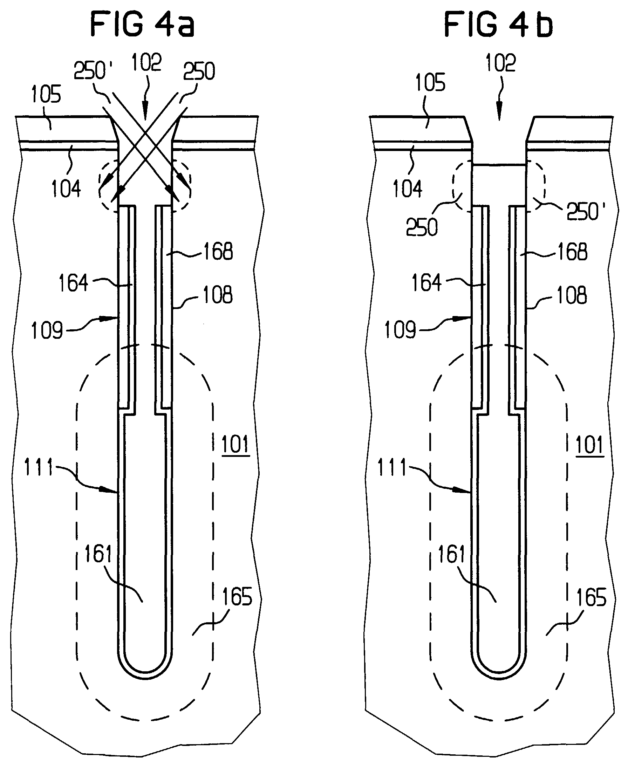

Weiter mit Bezug auf Fig. 7b wird die dielektrische Schicht beispielsweise durch reaktives Ionenätzen geätzt, um den Isolationskragen 168 zu bilden. Die chemischen Mittel für das reaktive Ionenätzen werden derart gewählt, daß das Oxid selektiv gegenüber der Isolationskragenopferschicht 152 und der Hartmaskenschicht 106, die aus Nitrid besteht, geätzt wird. Das reaktive Ionenätzen entfernt die dielektrische Schicht von der Oberfläche des Unterbaustapels und dem Boden des Grabens 108. Die dielektrische Schicht bleibt auf der Siliziumseitenwand, um den Isolationskragen 168 zu bilden. Wie in Fig. 4b abgebildet, ist der obere Bereich des Isolationskragens 168 leicht erodiert und bildet einen abgeschrägten oberen Abschnitt.

Mit Bezug auf Fig. 7c wird die Isolationskragenopferschicht 152 aus dem unteren Bereich 111 des Grabens 108 entfernt. Das Entfernen der Isolationskragenopferschicht 152 wird vorzugsweise durch CDE erreicht. Die dünne natürliche Oxidschicht 151 liegt dann typischerweise auf den freigelegten Grabenseitenwänden vor. Diese dünne natürliche Oxidschicht 151 reicht aus, um als CDE-Ätzstopp zu dienen. Ein CDE-Ätzschritt, beispielsweise unter Verwendung von NF₃ + Cl₂ als Chemikalien ätzt Silizium oder Polysilizium mit relativ hoher Selektivität gegenüber Oxid, was eine Entfernung des Polysiliziums unter Verwendung der dünnen natürlichen Oxidschicht 151 als Ätzstopp ermöglicht. Beispielsweise wurde eine Selektivität von etwa 4000:1 für das Entfernen des Polysiliziums, aus dem die Isolationskragenopferschicht 152 besteht, aus dem Graben 108 unter Verwendung der natürlichen Oxidschicht 151 als Ätzstoppschicht ermittelt.

Bei einer anderen Variante wird ein CDE-Schritt mit hohem Cl₂-Gehalt verwendet, um die Selektivität der Silizium- bzw. Polysiliziumätzung gegenüber dem Oxid zu erhöhen. Eine Strömungsrate von etwa 12 sccm resultiert in einer effektiven Oxidätzrate von null, während die Polysilizium-Ätzrate in der Größenordnung von etwa 2 µm/min liegt. Dies ermöglicht, daß die natürliche Oxidschicht 151 als effizienter Ätzstopp für die Entfernung der Isolationskragenopferschicht 152 dient. Typischerweise beträgt die Dicke der natürlichen Oxidschicht 151 etwa 0,5 bis 3 nm.

Alternativ kann eine Naßätzung, beispielsweise unter Verwendung von KOH oder HF:HNO₃:CH₃COOH ebenfalls beim Entfernen der Isolationskragenopferschicht 152 verwendet werden. Die Verwendung von KOH jedoch kann zu einer K-Kontamination auf der Grabenseitenwand führen, was einen zusätzlichen Reinigungsschritt erfordern kann. Eine reaktive Ionenätzung ist ebenfalls möglich beim Entfernen der Isolationskragenopferschicht 152, da sie anisotrop wirkt. Geeignete Chemikalien für die reaktive Ionenätzung für die Beseitigung der Isolationskragenopferschicht 152 enthalten SF₆/NF₃/HBr. Andere geeignete Chemikalien, welche Polysilizium selektiv gegenüber Oxid oder Nitrid ätzen, sind beispielsweise NF₃/HBr oder CF₄/O₂ oder CF₄/O₂/Cl₂.

Die Selektivität der reaktiven Ionenätzung hinsichtlich Polysilizium gegenüber Oxid oder Nitrid beträgt etwas weniger als 100:1 auf planaren Oberflächen, aber steigt auf mehr als etwa 2000:1 auf vertikalen Oberflächen, und zwar aufgrund der vorzugsweise vertikalen Richtung der Bewegung der Ionen während der reaktiven Ionenätzung. Aufgrund der hohen Selektivität des Polysiliziums gegenüber Oxid oder Nitrid auf den vertikalen Oberflächen wird nur der obere Bereich des Isolationskragens 168 erodiert. Jedoch ist dies kein Problem, da der Isolationskragen 168 nicht unterhalb der Oberfläche des Substrats erodiert wird.

Nach Entfernung der Isolationskragenopferschicht 152 wird die vergrabene Platte 165 mit n-Typ-Dotierstoffen, wie z.B. As oder P, als äußere Kondensatorelektrode gebildet. Der Isolationskragen 168 dient als Implantationsmaske, die ermöglicht, daß nur der Bereich unterhalb des Isolationskragens 168 dotiert wird. Die Konzentration der Dotierstoffe beträgt etwa 1 x 10¹⁹ - 10²⁰ cm⁻³. Zur Bildung der vergrabenen Platte 165 kann eine Gasphasendotierung unter Verwendung von PH₃ oder AsH₃, eine Plasmadotierung oder eine Plasmaimmersions-Ionenimplantation (PIII) verwendet werden. Solche Techniken sind beispielsweise in Ransom et al., J. Electrochemical. Soc. Band 141, Nr. 5 (1994), S. 1378 ff. und US-Patent Nr. 4,937,205 beschrieben.

Eine Ionenimplantation unter Verwendung des Isolationskragens 168 als Isolationsmaske ist ebenfalls möglich. Alternativ kann die vergrabene Platte 165 unter Verwendung eines dotierten Silikatglases, wie z.B. ASG, als Dotierstoffquelle gebildet werden. Die Verwendung von dotiertem Silikatglas als Dotierstoffquelle ist beispielsweise beschrieben in Becker et al., J. Electrochemical. Soc., Band 136 (1989), S. 3033 ff. Wenn datiertes Silikatglas verwendet wird, wird die Silikatglas-Schicht nach der Bildung der vergrabenen Platte 165 entfernt.

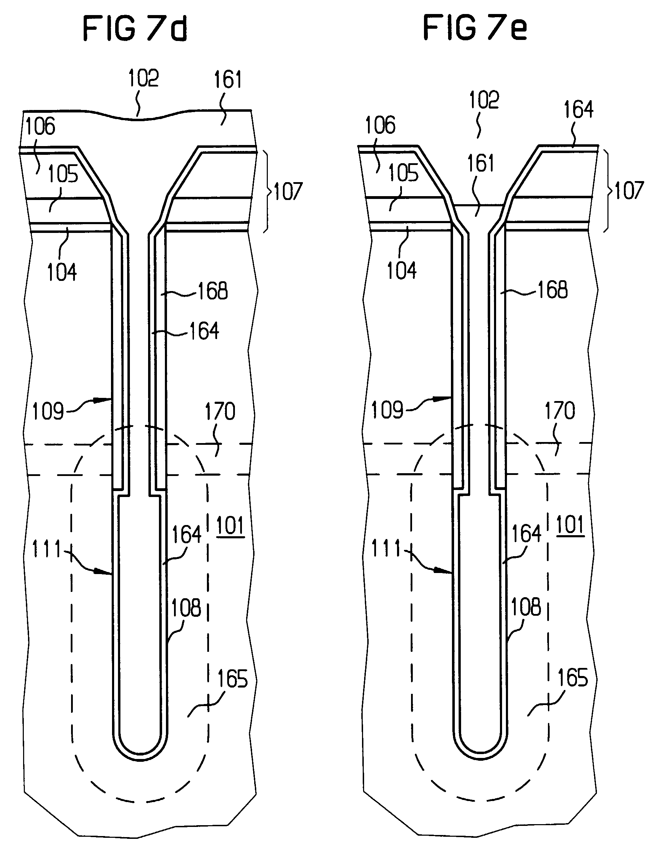

Mit Bezug auf Fig. 7d wird eine dielektrische Schicht 164 auf dem Wafer abgeschieden, welche die Oberfläche des Unterbaustapels 107 und das Innere des Grabens 108 bedeckt. Die dielektrische Schicht 164 dient als Speicherdielektrikum zum Separieren der Kondensatorelektroden. Bei einer Variante umfaßt die dielektrische Schicht 164 einen NO-Film-Stapel. Der NO-Film-Stapel wird durch Abscheiden einer Nitridschicht gebildet, welche dann reoxidiert wird. Die Nitridschicht wird beispielsweise durch thermische Nitrierung und CVD-Nitrid mit einer Dicke von etwa 5 nm ausgebildet. Die Nitridschicht wird beispielsweise bei einer Temperatur von etwa 900°C reoxidiert. Die Reoxidation der Nitridschicht erhöht die Dicke der Nitridschicht marginal. Weitere Typen von dielektrischen Filmstapeln, wie z.B. Oxid-Nitrid-Oxid (ONO) oder Oxid-Nitrid-Oxid-Nitrid (ONON), sind ebenfalls nützlich. Ebenfalls ist die Verwendung eines dünnen Oxids, Nitrids oder nitrierten Oxidfilms möglich.

Eine leitende Grabenfüllung 161 wird auf der Oberfläche des Wafers zum Bedecken des Unterbaustapels 107 und zum Füllen des Grabens 108 aus Polysilizium abgeschieden, und zwar beispielsweise durch CVD oder andere bekannte Techniken. Wie gezeigt, ist die leitende Grabenfüllung 161 konform und mit n-Typ-Datierstaffen datiert, wie z.B. P und As. Bei einer Variante ist die leitende Grabenfüllung 161 ein mit As datiertes Polysilizium. Die Konzentration von As beträgt etwa 1 x 10¹⁹ - 1 x 10²⁰ cm⁻³. Die leitende Grabenfüllung 161 dient als innere Kondensatorelektrode. Alternativ kann die leitende Grabenfüllung 161 aus amorphem Silizium bestehen. Dieses Material kann entweder in situ oder sequentiell dotiert werden.

Mit Bezug auf Fig. 7e wird die leitende Grabenfüllung 161 beispielsweise durch einen CDE-Schritt oder durch einen RIE-Schritt unter Verwendung geeigneter Chemikalien, wie z.B. NF₃/Cl₂ oder NF₃/HBr oder SF₆ abgesenkt. Bei einer anderen Variante wird die leitende Grabenfüllung 161 auf etwa die Höhe der Hartmaskenschicht 106 abgesenkt. Dies schützt vorteilhafterweise die Unterbau-Oxidschicht 104 während der folgenden Naßätzprazesse. Falls eine Unterätzung kein Problem darstellt, kann das Polysilizium bis zu der Tiefe der vergrabenen Brücke 162 eingesenkt werden.

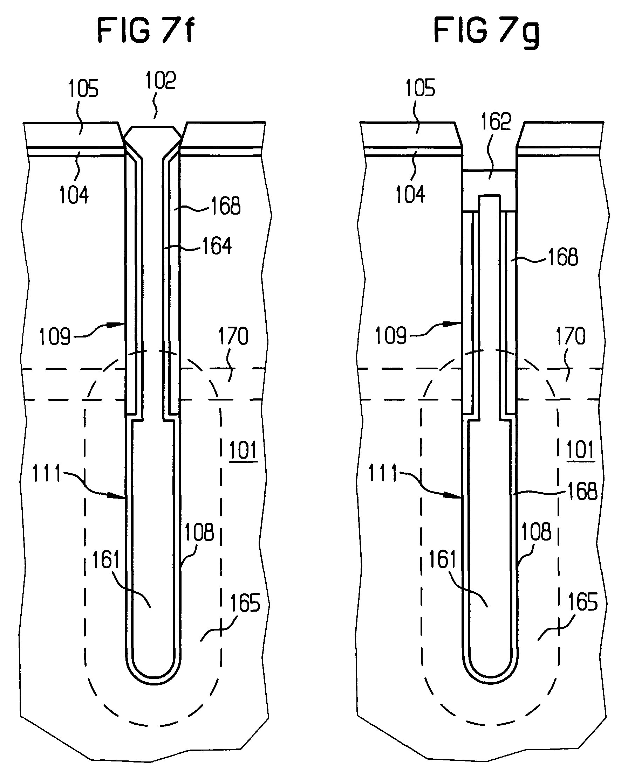

Gemäß Fig. 7f wird der Teil der dielektrischen Schicht 164, der sich oberhalb der leitenden Grabenfüllung 161 befindet mit einer Naßätzung entfernt, und zwar beispielsweise mit DHF und HF/ Glyzerol. Die Hartmaskenschicht 106 wird dann ebenfalls naßchemisch entfernt, und zwar mit BHF. Auch ist dazu die Durchführung eines CDE-Schrittes möglich. Die Hartmaskenschicht 106 kann auch früher im Prozeßablauf entfernt werden, wie z.B. nach der Bildung des Grabens 108. Wie gezeigt, sind der Isolationskragen 168 und die dielektrische Schicht 164 ebenfalls leicht in den Graben 108 eingesenkt.

Wie in Fig. 7g gezeigt, wird dann die leitende vergrabene Brücke 162 gebildet. Zur Bildung der leitenden vergrabenen Brücke 162 wird beispielsweise durch eine Ätzung die leitende Grabenfüllung 161 in den Graben 108 eingesenkt. Typischerweise wird hierzu eine reaktive Ionenätzung verwendet. Der nicht-aktive Bereich ist der Bereich, in dem die Grabenisolierung 180 zu bilden ist. Der nicht-aktive Bereich der Zelle wird dann durch eine übliche fotolithographische Technik definiert und dann anisotrop geätzt, und zwar zweckmäßigerweise durch reaktives Ionenätzen.

Wie mit erneutem Bezug auf Fig. 6 gezeigt, überlappt die Grabenisolierung 180 einen Teil des Grabens 108, um so einen Teil der leitende vergrabenen Brücke 162 abzuschneiden. In einem folgenden Temperaturschritt diffundieren Dotierstoffe aus der leitenden Grabenfüllung 161 nach oben und nach außen durch die leitende vergrabene Brücke 162 und Bilden den vergrabenen Kontakt 250. Die Tiefe der Grabenisolierung 180 beträgt etwa 0,25 µm. Typischerweise wird der nicht-aktive Bereich zur Bildung des Isolationsgrabens 180 bis unterhalb der Oberseite des Isolationskragens 168 geätzt. Bei einer Variante wird der nicht-aktive Bereich etwa 0,25 µm unterhalb der Substratoberfläche geätzt.

Nachdem der nicht-aktive Bereich geätzt ist, werden die Fotolack- und ARC-Schichten entfernt. Um zu gewährleisten, daß keine Fotolack- oder ARC-Rückstände zurückbleiben, können Reinigungsschritte verwendet werden. Um zu verhindern, daß Sauerstoff in die Silizium- und Polysiliziumseitenwände diffundiert, ist eine (nicht gezeigte) optionale Verkleidung vorgesehen, um den nicht-aktiven Bereich zu schützen. Die Verkleidung umfaßt beispielsweise Nitrid. Typischerweise wird ein Passivierungsoxid thermisch auf dem freiliegenden Silizium vor der Bildung der Nitridauskleidung aufgewachsen. Die Nitridauskleidung wird beispielsweise durch chemische Niederdruck-Dampfabscheidung (LPCVD) gebildet.

Ein dielektrisches Material wird auf der Oberfläche des Substrats gebildet. Das dielektrische Material weist beispielsweise SiO₂ auf. Bei einer weiteren Variante ist das dielektrische Material TEOS. Ein Hochdichteplasma-(HDP)Oxid oder ein anderes Isolationsmaterial kann verwendet werden. Die Dicke der dielektrischen Schicht reicht aus und bildet die Grabenisolierung 180 zum Füllen des nicht-aktiven Bereichs. Da die dielektrische Schicht typischerweise konform ist, werden Planarisierungsverfahren, wie z.B. chemischmechanisches Polieren, angewendet. Solche Verfahren sind beispielsweise beschrieben in Nesbit et al., A 0,6 µm² 256Mb Trench DRAM Cell With Self-Aligned Buried Strap (BEST), IEDM 93-627. Die Oberfläche des Substrats 101 wird dann derart poliert, daß die Grabenisolierung 180 und die aus Nitrid bestehende Unterbau-Stoppschicht 105 im wesentlichen planar sind und auf gleicher Höhe abschließen.

Die Unterbau-Stoppschicht 105 wird dann beispielsweise durch eine naßchemische Ätzung entfernt. Die naßchemische Ätzung ist selektiv gegenüber Oxid. Die Unterbau-Oxidschicht 104 wird ebenfalls an diesem Punkt durch eine naßchemische Ätzung entfernt, welche selektiv gegenüber Silizium ist. Nach Entfernung der Unterbau-Oxidschicht 104 wird eine Oxidschicht auf der Oberfläche des Wafers gebildet. Diese Oxidschicht, welche als Gate-Opferschicht 103 bezeichnet wird, dient als Streuoxid für nachfolgende Implantationen.

Zur Definition eines Bereichs für eine p-Typ-Wanne für den n-Kanal-Transistor 110 der DRAM-Speicherzelle wird eine Fotolackschicht auf der Oberseite der Oxidschicht abgeschieden und geeignet strukturiert, um den p-Wannenbereich freizulegen. Wie gezeigt, werden p-Typ-Dotierstoffe, wie z.B. Bor (B) in den Wannenbereich implantiert. Die Dotierstoffe werden hinreichend tief implantiert, um einen Punchthrough in den Transistor 110 zu verhindern und den Schichtwiderstand zu reduzieren. Das Dotierstoffprofil ist derart bemessen, daß die erwünschten elektrischen Charakteristika erhalten werden, wie z.B. eine erwünschte Einsatzspannung (Vₜₕ).

Zusätzlich werden ebenfalls p-Typ-Wannen für die n-Kanal-Versorgungsschaltungsanordnung gebildet. Für komplementäre Wannen in komplementären Metalloxid-Silizium-Bauelementen (CMOS) werden n-Typ-Wannen gebildet. Die Bildung von n-Typ-Wannen erfordert zusätzlich fotolithographische Schritte und Implantationsschritte zum Definieren und Bilden der n-Typ-Wannen. Wie bei den p-Typ-Wannen sind die Profile der n-Typ-Wannen auf das Erreichen der erwünschten elektrischen Charakteristika zugeschnitten. Nach Bildung der Wannen wird die Gate-Opferschicht 103 entfernt.

Die verschiedenen Schichten zum Bilden des Gates 112 des Transistors 110 werden dann hergestellt. Dies umfaßt das Bilden einer Gate-Oxidationsschicht, welche als Gate-Oxid dient, einer Polysiliziumschicht und einer Decknitridschicht. Typischerweise kann die Polysiliziumschicht eine Metallsilizidschicht, wie z.B. WSiₓ, enthalten, wobei das gebildete Polycide den Schichtwiderstand reduziert. Die verschiedenen Gate-Schichten werden dann strukturiert, um das Gate 112 des Transistors 110 zu bilden. Die Seitenwand des Gates 112 wird dann z.B. durch thermische Oxidation isoliert.

Eine passierende Wortleitung 120' wird typischerweise über dem Graben 108 gebildet und ist von ihm durch die Grabenisolierung 180 isoliert. Das Dram-Gebiet 113 und das Source-Gebiet 114 werden durch Implantieren von n-Typ-Dotierstoffen, wie z.B. P oder As gebildet. Bei einer Variante wird P in das Source-Gebiet 114 und das Dram-Gebiet implantiert. Die Dosis und die Energie werden derart ausgewählt, daß ein Dotierstoffprofil erzielt wird, welches die erwünschten Betriebscharakteristika gewährleistet. Zur Verbesserung der Diffusion und der Ausrichtung des Source-Gebiets 114 und des Drain-Gebiets 113 mit dem Gate können Nitridabstandshalter (Spacer) (nicht gezeigt) verwendet werden. Das Source-Gebiet 114 ist mit dem vergrabenen Kontakt 250 verbunden, um so den Kondensator an den Transistor 110 anzuschließen.

Die Isolationsschicht 189 wird über der Waferoberfläche gebildet, und sie überdeckt die Gates 112 und die Substratoberfläche. Die Isolationsschicht 189 umfaßt beispielsweise BPSG. Weitere dielektrische Materialien, wie z.B. TEOS, sind ebenfalls nützlich. Wie gezeigt, wird ein randloser Kontakt 183 geätzt, um das Drain-Gebiet 113 freizulegen. Der randlose Kontakt 183 wird dann aus einem leitenden Material, wie z.B. n⁺-dotierten Polysilizium gefüllt. Die Bitleitung 185, wird über der Isolationsschicht 189 ,gebildet, um einen Kontakt mit dem Drain-Gebiet 113 über den randlosen Kontakt 183 zu bilden.

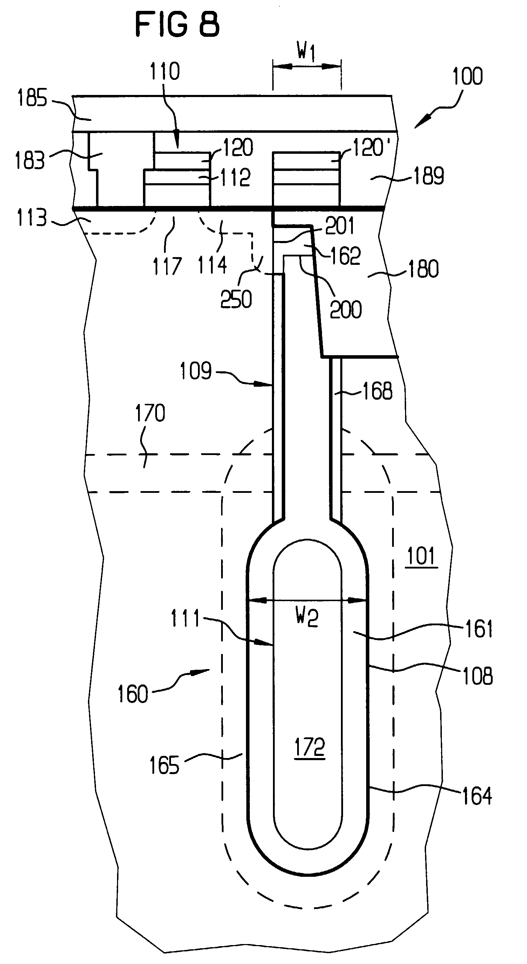

Fig. 8 zeigt ein weiteres Beispiel einer üblichen DRAM-Speicherzelle entsprechend einer weiteren Verfahrensvariante. Wie dort gezeigt, ist die Breite W₂ bzw. der Durchmesser des unteren Bereichs 111 des Grabens 108 größer als die Breite W₁ bzw. der Durchmesser des oberen Bereichs 109. Die Vergrößerung von W₁ erhöht die Kapazität des Grabenkondensators 160. Zum Erzielen solch einer Struktur wird die in Fig. 7b beschriebene Isolationskragenopferschicht 152 beispielsweise mit CDE unter Verwendung von NF₃/Cl₂ entfernt. Weitere Chemikalien zum selektiven Ätzen von Silizium sind ebenfalls verwendbar. Zusätzlich ist eine reaktive Ionenätzung unter Verwendung von SF₆, NF₃/HBr oder eine Naßätzung unter Verwendung von KOH anwendbar. Der untere Bereich 111 des Grabens 108 wird beispielsweise durch eine CDE-Ätzung aufgeweitet. Die Aufweitung des Grabens 108 ist beispielsweise beschrieben in T. Ozaki et al., 0,228 µm² Trench Cell Technologies with Bottle-shaped Capacitor for 1 Gigabit DRAMs, IEDM 95, pp. 661 oder US-Patent Nr. 5,336,912 von S. Ohtsuki. Das Ätzmittel für die CDE-Ätzung ist derart ausgewählt, daß es ebenfalls den dünnen natürlichen Oxidfilm auf den Grabenseitenwänden entfernt. Dies kann durch Reduzieren der Strömungsrate von Cl₂ erzielt werden, um die Selektivität der Ätzung gegenüber Oxid zu erniedrigen, oder durch Änderung der Chemikalien.

Die Naßätzung oder die CDE ist so gesteuert, daß sie die Isolationskragenopferschicht 152 entfernt, während sie die Aufweitung derart begrenzt, daß sie sich nicht in benachbarte Gräben erstreckt oder diese kontaktiert. Die Aufwei-tung des unteren Bereichs 111 des Grabens 108 beträgt etwa 50% des minimalen Abstands zwischen benachbarten Gräben, und vorzugsweise weniger als 20-30% des minimalen Abstands zwischen benachbarten Gräben. Da der Abstand zwischen benachbarten Gräben typischerweise minimales Lithographiemaß F beträgt, sollte die Aufweitung auf weniger als 50% des minimalen Lithographiemaßes begrenzt sein. Dies liefert beispielsweise einen Graben mit Flaschengestalt, dessen unterer Durchmesser weniger als das doppelte minimale Lithographiemaß F beträgt. Vorzugsweise beträgt die Aufweitung des Grabens etwa 20-40% des minimalen Lithographiemaßes F.

Nach Entfernen der Isolationskragenopferschicht 152 und der natürlichen Oxidschicht 151, die als Ätzstoppschicht dient, kann die vergrabene Platte 165 gebildet werden. Verschiedene Techniken zum Bilden der vergrabenen Platte 165, wie z.B. Gasphasendotierung mit AsH₃ oder PH₃ bei Temperaturen von etwa 1000-1100°C, Ionenimplantation von As oder P, Plasmadotierung oder Plasmaiimmersions-Ionenimplantation sind möglich. Ein dotiertes Polysilizium wird dann abgeschieden, um die leitende Grabenfüllung 161 zu bilden. Das dotierte Polysilizum füllt den unteren Bereich 111 des Grabens 108 unter Bildung eines Hohlraums 172. Da der Hohlraum 172 in dem unteren Bereich 111 des Grabens 108 liegt, beeinflußt er die folgende Verarbeitung oder Funktionalität der Vorrichtung nicht. Weitere Techniken zum Erhöhen der Grabenkapazität, wie z.B. die Bildung von halbkugelartigen Siliziumkörnern (HSG) in dem Graben 108 oder das Aufrauhen der Grabenseitenwände vor der Abscheidung der dielektrischen Schicht 164 sind ebenfalls möglich.

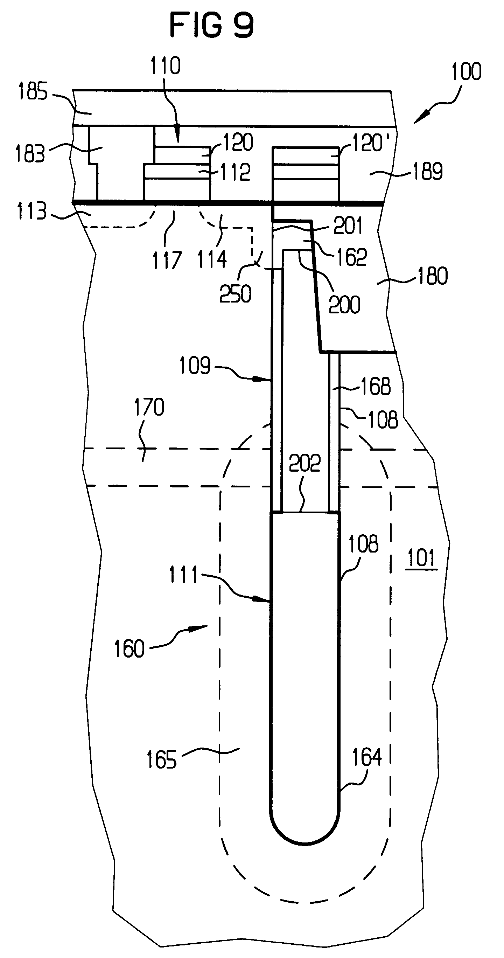

Fig. 9 zeigt eine weitere übliche DRAM-Speicherzelle, bei welcher der Grabenkondensator 160 herstellungsgemäß eine weitere Grenzfläche 202 zwischen dem unteren Bereich 111 des Grabens 108 und dem oberen Bereich 109 des Grabens 108 aufweist. Die weitere Grenzfläche 202 rührt dabei von einem zweistufigen Polysilizium-Füllprozeß her, bei dem der Graben zuerst mit Polysilizium gefüllt wird, dieses dann zur Bildung des Isolationskragens 168 eingesenkt wird und dann schließlich nach Bildung des Isolationskragens 168 wieder aufgefüllt wird. Ein derartiges Verfahren ist beispielsweise in dem US-Patent A-5,360,758 von Bronner et al. beschrieben.

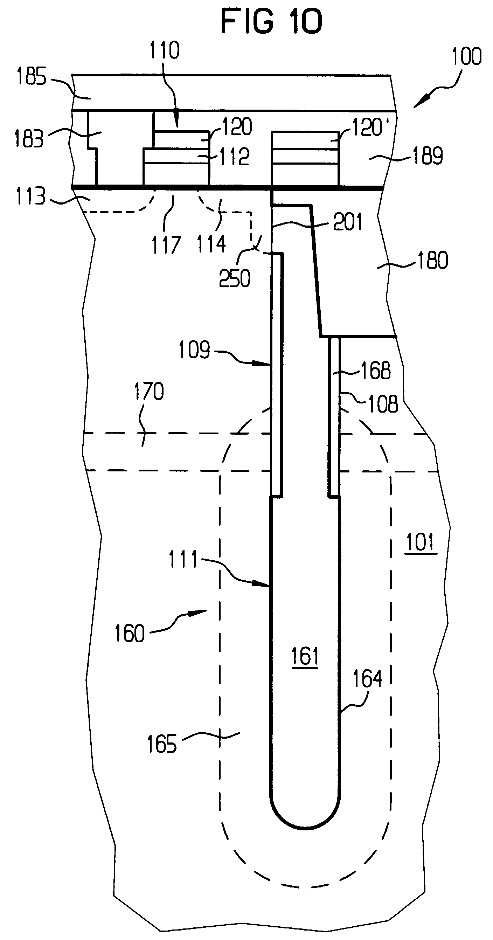

Fig. 10 zeigt eine weitere übliche DRAM-Speicherzelle entsprechend einer weiteren Verfahrensvariante. Wie mit Bezug auf Figur 6 gezeigt, gibt es bei dieser Variante der DRAM-Speicherzelle eine Grenzfläche 201 und eine zusätzliche Grenzfläche 200. Die zusätzliche Grenzfläche 200 liegt zwischen der leitenden Grabenfüllung 161 und der leitenden vergrabenen Brücke 162 und die Grenzfläche 201 liegt zwischen der leitenden vergrabenen Brücke 162 und dem vergrabenen Kontakt 250, der in dem Substrat 101 gebildet ist.

Die beiden Grenzflächen 200 und 201 weisen einen erhöhten elektrischen Widerstand auf und verlangsamen somit die Geschwindigkeit der Schreib/Lese-Zyklen der DRAM-Zelle. Die zusätzliche Grenzfläche 200 ist typischerweise eine Polysilizium/Polysilizium-Grenzfläche, und die Grenzfläche 201 ist typischerweise eine Silizium-Einkristall/Polysilizium-Grenzfläche.

Die in Figur 10 gezeigte Variante einer DRAM-Speicherzelle weist nur die Grenzfläche 201 zwischen der leitenden Grabenfüllung 161 und dem vergrabenen Kontakt 250 im Substrat 101 auf. Die leitende vergrabene Brücke 162 ist bei dieser Variante nicht vorgesehen.

Somit weist diese Variante einen geringeren Übergangswiderstand zwischen Transistor 110 und dem Grabenkondensator 160 auf, was seine Anfälligkeit gegenüber Ausfällen beim Transfer von Ladung von und zu dem Grabenkondensator 160 bei Lese/Schreib-Zyklen reduziert bzw. eine höhere Geschwindigkeit von Lese/Schreib-Zyklen ermöglicht.

Die Grenzfläche 201 kann ein natürliches Oxid (z.B. 0,3-0,8 nm) von einer vorhergehenden Naßvorreinigung sein, oder sie kann eine geeignete aufgewachsene oder abgeschiedene Schicht, wie z.B. thermisches Oxid oder CVD-Oxid, Oxynitrid oder Nitrid, mit Dicken im Bereich von typischerweise 0,3-2 nm sein. Eine In-Situ-Vorreinigung mit H₂, HF-Dampf oder ein UHV-Temperaturschritt können ebenfalls vor der Bildung der Grenzfläche 201 durchgeführt werden.

Die besondere Bedeutung der Grenzfläche 201 liegt im Vermeiden einer unkontrollierten Rekristallisierung und Defektbildung an der Grenzfläche 201 des vergrabenen Kontakts 250. Ein wichtiger Vorteil dieser Variante liegt darin, daß es nur noch die Grenzfläche 201 für den vergrabenen Kontakt gibt, da die Grabenfüllung nach Bildung des vergrabenen Kontakts 250 durchgeführt wird. Somit ist der Widerstand für die Lese/Schreib-Zyklen viel geringer, und die Prozeßausbeute ist entsprechend besser.

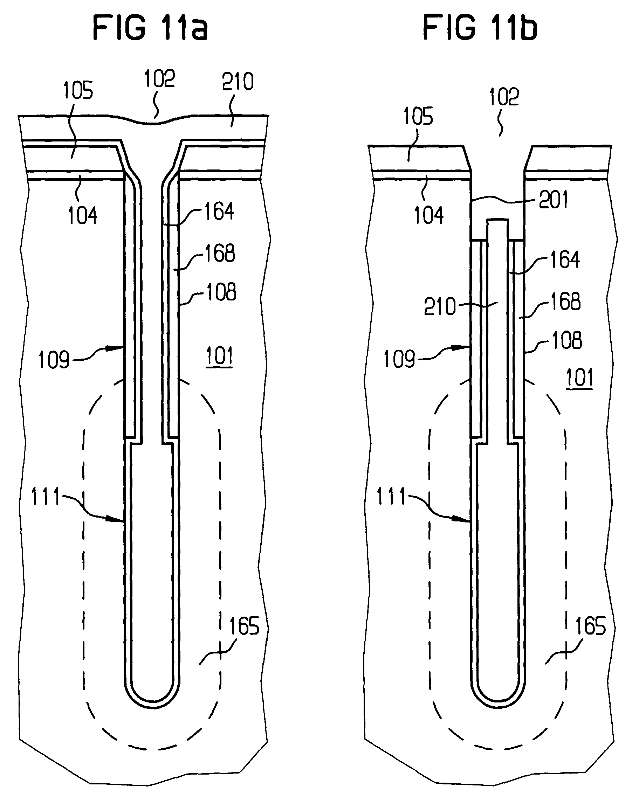

Fig. 11a-d zeigen eine Variante des Verfahrens zur Herstellung der DRAM-Speicherzelle nach Fig. 10.

Wie in Figur 11a gezeigt, welche sich an das Prozeßstadium gemäß Figur 7c anschließt, ist die Hartmaskenschicht 105 entfernt, ist die dielektrische Schicht 164 im Graben 108 und auf der Substratoberfläche aufgebracht und ist der Graben 108 mit einem Opfermaterial 210, hier z.B. mit einem Fotolack, gefüllt.

Wie in Figur 11b illustriert, wird zunächst das Opfermaterial 210 mittels einer CDE-Ätzung eingesenkt, und darauffolgend wird der obere Bereich des Isolationskragens 168 zusammen mit der darauf befindlichen dielektrischen Schicht 164 eingesenkt, um den vergrabenen Kontakt 250 an der Grenzfläche 201 in dem Substrat 101 zu definieren. Auch dies geschieht mittels einer CDE-Ätzung, welche gegenüber dem Opfermaterial 210 und dem Substrat 101 selektiv ist, oder mittels einer entsprechenden Naßätzung.

Eine Alternative zu der Verwendung von Fotolack als Opfermaterial 210 ist die Verwendung einer hochdotierten Polysiliziumschicht (n-dotiert) bzw. amorphen Siliziumschicht, die mittels CDE selektiv zu Oxid, Nitrid und dem noch undotierten Substrat 101 im Bereich der Grenzfläche 201 geätzt werden kann. Der Vorteil dabei liegt in einer besseren Steuerbarkeit des Einsenkens.

Optionellerweise kann die dielektrische Schicht 164 nach dem Einsenken des Isolationskragens 168 von den Seitenwänden des vorstehenden Opfermaterials 210 entfernt werden.

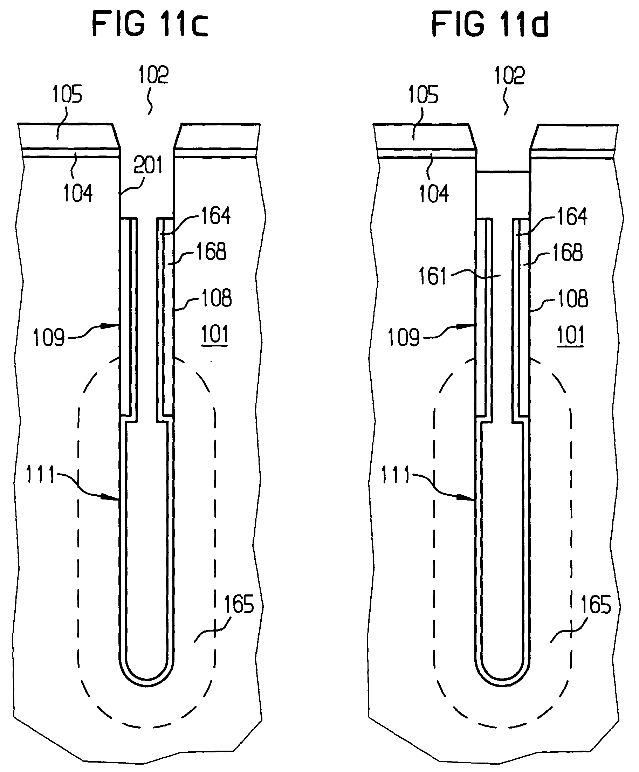

Wie in Figur 11c gezeigt, wird anschließend das Opfermaterial 210 beispielsweise durch eine CDE-Ätzung oder eine Naßätzung entfernt.

Anschließend erfolgt mit Bezug auf Figur 11d eine Vorreinigung mittels eines H₂-Temperaturschritts oder einem HF-Dampfschritt oder einem UHV-Temperaturschritt. Eine konventionelle naßchemische Vorreinigung (z.B. BHF o.ä.) ist ebenfalls möglich.

Optionellerweise wird eine Tunnelschicht 205 auf der Grenzfläche 201 gebildet. Beispielsweise handelt es sich bei der Tunnelschicht 205 um ein dünnes Oxid oder Nitrid oder Oxynitrid, und zwar mit oder ohne der Vorreinigung vom vorherigen Schritt, nämlich in situ, d.h. der Wafer wird dabei nicht der Reinraumatmosphäre ausgesetzt.

Es folgt die Abscheidung der leitenden Grabenfüllung 161 zum Auffüllen des Grabens 108 und zum Verbinden desselben mit der Grenzfläche 201 im oberen Bereich 109 des Grabens 108. Die leitende Grabenfüllung 161 ist, wie erwähnt, üblicherweise mit As, P mit einer Konzentration von 10¹⁹ cm⁻³ - 10²¹ cm⁻³ dotiert. Letztlich wird die leitende Grabenfüllung 161 planarisiert und z.B. ca. 50 nm unter die Substratoberfläche eingesenkt, um so zu dem in Figur 11d gezeigten Prozeßstadium zu gelangen. Die weiteren Prozeßschritte sind derart, wie im Zusammenhang mit der Variante nach Figur 7g beschrieben.

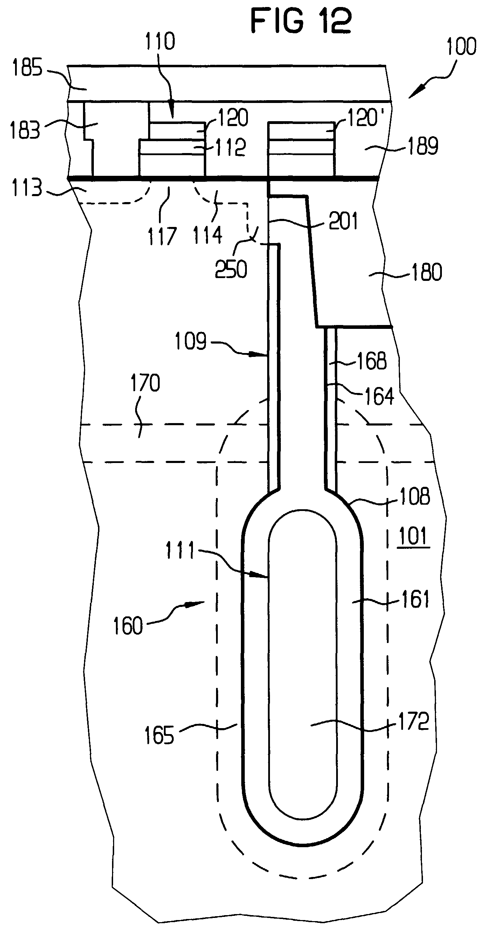

Fig. 12 zeigt ein weiteres Beispiel einer üblichen DRAM-Speicherzelle entsprechend einer weiteren Verfahrensvariante. In Analogie zu Figur 8 kann die letztere Variante nämlich auch für einen flaschenförmigen Graben 108 verwendet werden, was in Figur 12 illustriert ist.

Die besonderen Vorteile dieser beiden letzteren Varianten liegen darin, daß ein Grabenkondensator 160 mit vergrabenem Kontakt 250 bereitgestellt wird, welche nur die Grenzfläche 201, Polysilizium/Einkristall-Silizium, aufweist, wohingegen üblicherweise mindestens die Grenzfläche 201 und die zusätzliche Grenzfläche 200 vorgesehen sind.

Die besonderen Schritte dieser beiden Varianten sind das Bilden des Isolationskragens 168 vor der Abscheidung der dielektrischen Schicht 164 und das Definieren des vergrabenen Kontakts 250 mit einem Opfermaterial-Einsenkprozeß. Das Opfermaterial 210, welches selektiv zum Kragen (Oxid), Dielektrikum (Nitrid) und Substrat (Silizium) entfernbar ist, kann beispielsweise aus Fotolack oder As- oder P-dotiertes Polysilizium, welches mittels CDE selektiv zu Oxid, Nitrid und undotiertem oder p-dotiertem Silizium ätzbar ist.

Problematisch bei allen angeführten bekannten Varianten ist die Bildung des Anschlusses des Grabenkondensators 160 an der Grenzfläche 201 zwischen dem vergrabenen Kontakt 250 und der leitenden vergrabenen Brücke 162 bzw. der leitenden Grabenfüllung 161. Etwaige Fehler bzw. Störungen in diesem Anschlußbereich können einen erhöhten Übergangswiderstand oder viel dramatischer zu Versetzungen im Substrat führen, die Leckströme zwischen den beiden Kondensatorelektroden verursachen und damit Fehler bei Schreib/ Lesezyklen verursachen.

Zum Vermeiden von Fehlern und der damit verbundenen Ausfälle bietet sich der Einbau einer Tunnelschicht 205 an der Grenzfläche 201 an, die z.B. aus thermischem Oxid, Nitrid oder Oxynitrid bestehen kann.

Verwendet man eine dünne Tunnelschicht 205, bricht diese bei nachfolgenden thermischen Prozessen von typischerweise 1100 °C (z.B. Oxidation nach Ätzen der Grabenisolierung) leicht auf, was zu unkontrollierter Siliziumrekristallisation und entsprechenden Versetzungen an der Grenzfläche 201 führt. Es kommt zu Kurzkanaleffekten oder Punchthrough des Auswahltransistors (Ausdiffusion wird zu stark) und zu einer unerwünschten Verringerung der Haltezeit (Retention Time).

Verwendet man eine dicke Tunnelschicht 205, die bei nachfolgenden thermischen Prozessen nicht aufbricht, unterdrückt diese die Ausdiffusion und verschlechtert die Kontaktierung wegen eines erhöhten Übergangswiderstands und damit verbundenen Fehlern bei den Schreib/Lesezyklen.

Daher ist die übliche Lösung mit Ausdiffusion durch die Grenzfläche 201 unbefriedigend, weil sich die Kontaktierung des Transistors 110 nur schlecht kontrollieren läßt.

Die Aufgabe der vorliegenden Erfindung besteht daher darin, einen verbesserten Grabenkondensator mit einem Isolationskragen zu schaffen, welcher eine besser kontrollierbare Kontaktierung aufweist. Eine weitere Aufgabe der Erfindung liegt in der Bereitstellung eines entsprechenden Herstellungsverfahrens.

Erfindungsgemäß wird diese Aufgabe durch den in Anspruch 1 angegebenen Grabenkondensator 160 mit einem Isolationskragen 168 gelöst.

Weiterhin wird diese Aufgabe durch das in Anspruch 6 angegebene Verfahren gelöst.

Bevorzugte Weiterbildungen sind Gegenstand der jeweiligen Unteransprüche.

Der erfindungsgemäße Grabenkondensator 160 bzw. das erfindungsgemäße Herstellungsverfahren weisen gegenüber den bekannten Lösungsansätzen den Vorteil auf, daß der Widerstand an der Grenzfläche 201 stark erniedrigt ist. Insbesondere sind die Ausfälle aufgrund von unterschiedlicher Haltezeit reduziert und gleichzeitig die Prozeßausbeute erhöht. Die Möglichkeit, die Speicherzelle 100 zu verkleinern ist erhöht, da der elektrische Kontakt mit dem Transistor 110 nicht durch Ausdiffusion von As und P aus der leitenden Grabenfüllung 161 durchgeführt wird, sondern durch direkte Dotierung (Ionenimplantation, PLAD oder PIII, Gasphasendotierung) und somit die Übergangstiefe von größer 100 nm auf kleiner 50 nm an dem vergrabenen Kontakt 250 zwischen der leitenden vergrabenen Brücke 162 und dem Substrat 101 vermindert werden kann. Kurzkanaleffekte und Punchthrough des Transistors 110 sind somit vermeidbar.

Die der vorliegenden Erfindung zugrundeliegende Idee liegt in der Implantation (bzw. Plasmadotierung oder Gasphasendotierung) durch die Grenzfläche 201 und der Bildung einer optionalen Tunnelschicht 205, welche während der folgenden Prozeßschritte nicht aufbricht und somit keine Versetzungsbildung ermöglicht.

Eine Nitridbarriere (Barrierenhöhe 2 eV) ist einer Oxidbarriere (Barrierenhöhe 3,5 eV) wegen des höheren Tunnelstroms bei gleicher Dicke vorzuziehen. Auch die Bildung einer dünneren Oxynitrid-Schicht ist möglich.

Nitrid oder Oxynitrid können thermisch gebildet werden oder mittels (LP)CVD-Abscheidung oder Kombination aus thermischem Wachstum und CVD-Abscheidung oder CVD-Ahscheidung mit thermischer Verdichtung.

Ausführungsbeispiele der vorliegenden Erfindung sind in den Zeichnungen dargestellt und in der nachfolgenden Beschreibung näher erläutert.

In den Figuren zeigen:
- Fig. 1: ein Ausführungsbeispiel einer DRAM-Speicherzelle gemäß der vorliegenden Erfindung entsprechend einer ersten Ausführungsform des erfindungsgemäßen Verfahrens;
- Fig. 2a,b: die erste Ausführungsform des erfindungsgemäßen Verfahrens zur Herstellung der DRAM-Speicherzelle nach Fig. 1;
- Fig. 3: ein weiteres Ausführungsbeispiel einer DRAM-Speicherzelle gemäß der vorliegenden Erfindung entsprechend einer zweiten Ausführungsform des erfindungsgemäßen Verfahrens;
- Fig. 4a,b: die zweite Ausführungsform des erfindungsgemäßen Verfahrens zur Herstellung der DRAM-Speicherzelle nach Fig. 3;
- Fig. 5: ein weiteres Ausführungsbeispiel einer DRAM-Speicherzelle gemäß der vorliegenden Erfindung entsprechend einer dritten Ausführungsform des erfindungsgemäßen Verfahrens;
- Fig. 6: ein Beispiel einer üblichen DRAM-Speicherzelle;
- Fig. 7a-g: eine Variante des Verfahrens zur Herstellung der DRAM-Speicherzelle nach Fig. 6;
- Fig. 8: ein weiteres Beispiel einer üblichen DRAM-Speicherzelle;
- Fig. 9: ein weiteres Beispiel einer üblichen DRAM-Speicherzelle;
- Fig. 10: ein weiteres Beispiel einer üblichen DRAM-Speicherzelle;
- Fig. 11a-d: eine Variante des Verfahrens zur Herstellung der DRAM-Speicherzelle nach Fig. 10; und
- Fig. 12: eine weiteres Beispiel einer üblichen DRAM-Speicherzelle.
- Fig. 13: eine in situ Prozeßabfolge für die Bildung eines vergrabenen Kontakts.

In den Figuren bezeichnen gleiche Bezugszeichen gleiche oder funktionsgleiche Elemente.

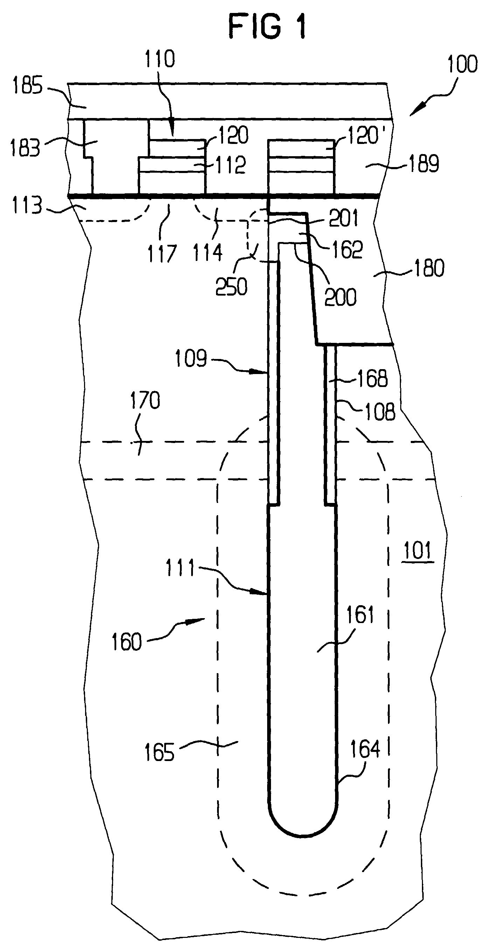

Fig. 1 zeigt ein Ausführungsbeispiel einer DRAM-Speicherzelle gemäß der vorliegenden Erfindung entsprechend einer ersten Ausführungsform des erfindungsgemäßen Verfahrens.

Mit Bezug auf Fig. 1 ist bei diesem Ausführungsbeispiel der DRAM-Speicherzelle ist der vergrabene Kontakt 250 vorzugsweise durch schräge Implantation von (z.B. As oder P) hergestellt und an der Grenzfläche 201 zwischen der leitenden vergrabenen Brücke 162 und dem Substrat 101 vorgesehen. Der vergrabene Kontakt 250 wird vor dem Aufwachsen der Tunnelschicht 205 (beispielsweise aus Nitrid, Oxynitrid oder Oxid) durchgeführt. Alternativ können ein isotroper Dotierungsprozeß, wie z.B. eine Plasmadotierung (PLAD) oder Plasmaimmersions-Ionenimplantation (PIII) oder eine Gasphasendotierung anstelle der schrägen Implantation verwendet werden. Das PLAD-Verfahren oder das PIII-Verfahren sind bevorzugt, da sie die Bildung von sehr flachen Obergängen erlauben.

Auch eine Implantation nach Ausbildung der Tunnelschicht 205 ist möglich. In diesem Fall dient die Tunnelschicht 205 als Streuschicht für die Implantation.

Im allgemeinen ermöglicht diese Ausführungsform die Reduzierung der Übergangstiefe des Kontaktbereichs für den Übergang von der leitenden vergrabenen Brücke 162 zum Substrat 101, was zur Vermeidung von Kurzkanaleffekten und eines Punchthrough des betreffenden Transistors 110 sehr wichtig ist.

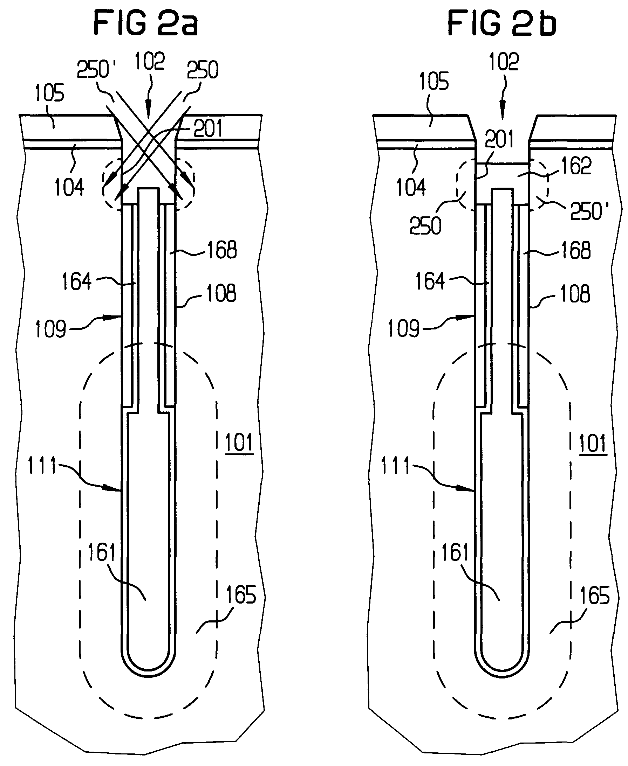

Fig. 2a,b zeigen die Ausführungsform des erfindungsgemäßen Verfahrens zur Herstellung der DRAM-Speicherzelle nach Fig. 1.

Wie in Fig. 2a gezeigt, welche dem Prozeßstadium von Figur 7e vor Aufbringung der leitenden vergrabenen Brücke 162 entspricht, wird - nach optioneller Abscheidung eines Streuoxids von beispielsweise 5 nm Dicke zur Vermeidung einer Beschädigung des Substratsiliziums während der Implantationen - eine schräge Implantation, beispielsweise mit As, P oder Sb, vorzugsweise mit As, durchgeführt, um den vergrabenen Kontakt 250 bzw. 250' zu bilden. Der Grund dafür, daß beide Seiten implantiert werden liegt darin, daß von zwei benachbarten Grabenkondensatoren 160 in der Regel der linke an der linken Grabenseite und der rechte an der rechten Grabenseite angeschlossen wird, wobei sie sich eine Grabenisolierung 180 teilen.

Falls ein Streuoxid aufgebracht wurde, wird es anschließend beispielsweise durch eine Naßätzung BHF entfernt.

Anschließend erfolgt eine Vorreinigung (z.B. naßchemisch (DHF, BHF) oder in situ (H₂-Prebake, HF-Dampf, HF/NH₃-Dampf, UHV-Anneal), und dann wird an die Grenzfläche 201 die Tunnelschicht 205, beispielsweise durch thermisches Aufwachsen von Siliziumnitrid (780°, 30 Minuten, NH₃, 1 Torr) oder Siliziu-moxynitrid oder Siliziumoxid mit einer Dicke im Bereich von 0,5-2 nm, vorzugsweise 0,8-1,5 nm durchgeführt. Dabei ist Nitrid bevorzugt wegen seiner geringen Barrierenhöhe von 2 eV gegenüber von Oxid mit 3,5 eV für Elektronentunnelströme bevorzugt.

Auch eine (LP)CVD-Abscheidung ist möglich, aber eine thermische Bildung oder eine Kombination aus CVD-Abscheidung und thermischer Verdichtung ist bevorzugt.

Anschließend wird, wie in Fig. 2b gezeigt, der Graben 108 mit der leitenden Grabenfüllung 161 gefüllt, letztere planarisiert und eingesenkt und schließlich die leitende vergrabene Brücke 162 in Form von Polysilizium in situ mit einer As- oder P-Dotierung größer 1x10¹⁹ cm⁻³ gebildet. Ebenfalls ist eine nachträgliche Dotierung der leitenden vergrabenen Brücke 162 möglich.

Darauf folgend wird das Verfahren fortgesetzt, wie in Zusammenhang mit Figur 7g beschrieben.

Ebenfalls möglich ist im übrigen eine isotrope Implantation, wobei in diesem Fall auch das obere Ende der leitenden Grabenfüllung 161 implantiert wird.

Schließlich kann anstelle einer Implantation auch eine Gasphasendotierung (z.B. 900-1100°C, 1 min., 760 Torr mit AsH₃ oder PH₃ oder 800-1050 °C mit AsH₃ oder PH₃ in einem Vertikalofen) zweckmäßigerweise ohne Streuoxid, welches als Diffusionsbarriere wirken würde zur Bildung des vergrabenen Kontakts, durchgeführt werden.

Während eine Implantation, PLAD oder PIII die Bildung besonders flacher vergrabener Kontakte 250 ermöglicht, kann eine Gasphasendotierung in situ und ohne Streuoxid vor der Bildung der Tunnelschicht 205 ausgeführt werden und bietet somit den Vorteil hoher Produktivität.

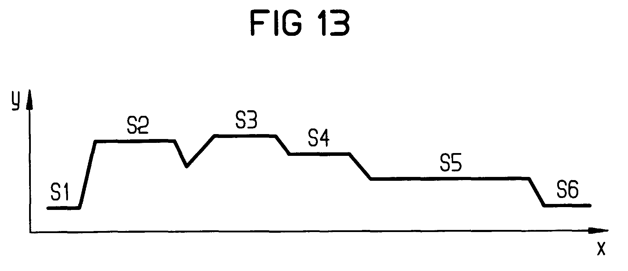

Die Prozeßführung für eine in situ Bildung des vergrabenen Kontakts 250 ist in Figur 13 dargestellt. Dabei ist auf der mit X bezeichneten Achse die Zeit und auf der mit Y bezeichneten Achse die Temperatur aufgetragen.
In dem Schritt S1 wird ein Ofen mit einem vorprozessierten Substrat 101 beladen.
In dem zweiten Schritt S2 findet ein optionaler Temperaturschritt in Wasserstoffatmosphäre statt (prebake). Dieser kann in einem Vertikalofen für mehrere Wafer bei etwa 950°C und 1 Torr für ca. 30 min, oder in einem Einzelscheiben-Clustertool bei etwa 950°C und 20 Torr für ca. eine Minute durchgeführt werden.
In dem darauffolgenden Schritt S3 wird die Gasphasendotierung, und damit die Bildung des vergrabenen Kontakts 250, durchgeführt. In einem speziellen Ausführungsbeispiel kann die Gasphasendotierung in einem Vertikalofen für mehrere Wafer bei 950°C und 1 Torr unter AsH₃ (Arsin) Atmosphäre in 30 Minuten durchgeführt werden. In einem zweiten Ausführungsbeispiel kann die Gasphasendotierung in einem Einzelscheiben-Clustertool bei 1100°C und 100 Torr in einer Minute durchgeführt werden.
In dem Schritt S4 wird an der Grenzfläche 201 des vergrabenen Kontakts 250 die Tunnelschicht 205 aus Oxid, Nitrid oder Oxynitrid gebildet. Zum Beispiel kann eine thermische Nitrid-Tunnelschicht in einem Vertikalofen für mehrere Wafer bei 780°C und 1 Torr unter NH₃ (Amoniak) Atmosphäre gebildet werden. Alternativ kann eine thermische Nitrid-Tunnelschicht in einem Einzelscheiben-Clustertool bei 800°C und 100 Torr in NH₃ (Amoniak) Atmosphäre gebildet werden.
Im Schritt S5 wird eine leitende vergrabene Brücke 162 gebildet, die beispielsweise aus n-dotiertem Polysilizium besteht. Durchgeführt wird die Bildung der vergrabenen Brücke beispielsweise bei 55°C und 0,6 Torr mit SiH₄ (Silan) als Ausgangsgas (Precursor) der CVD-Abscheidung. Sequentiell wird das gebildete Polysilizium von Zeit zu Zeit mit AsH₃ (Arsin) dotiert, so daß ein dotiertes Polysilizium entsteht. Alternativ wird ein dotiertes Polysilizium mittels CVD-Abscheidung unter Verwendung der beiden Ausgangsgase (Precursor) Silan und Arsin hergestellt. Das Polysilizium erhält bei diesem Verfahren eine Dotierstoffkonzentration von 10¹⁹cm⁻³ bis 10²⁰cm⁻³.
In dem Schritt S6 wird das Substrat aus dem Ofen entnommen. Der Vorteil der in situ Prozeßführung bei der Bildung des vergrabenen Kontakts 250 besteht in der Vermeidung von Verunreinigungen des Substrats 101 durch die Reinraumatmosphäre, einer strikten Zeitkopplung der einzelnen Prozeßabläufe, wodurch die Reproduzierbarkeit erhöht wird und einer Erhöhung des Durchsatzes, die durch Entfallen von Belade- und Entladevorgängen erreicht wird.

Diese Ausführungsform bietet weiterhin den Vorteil, daß der Widerstand an der Grenzfläche 201 stark erniedrigt ist. Insbesondere sind die Ausfälle aufgrund von unterschiedlicher Speicherzeit der Speicherzellen reduziert und gleichzeitig die Prozeßausbeute erhöht. Die Möglichkeit, die Speicherzelle 100 zu verkleinern ist erhöht, da der elektrische Kontakt mit dem Transistor 110 nicht durch Ausdiffusion von As und P aus der leitenden Grabenfüllung 161 durchgeführt wird, sondern durch Ionenimplantation, PLAD, PIII oder Gasphasendotierung und somit die Übergangstiefe von größer 100 nm auf kleiner 50 nm an dem vergrabenen Kontakt 250 zwischen leitender vergrabener Brücke 162 und dem Substrat 101 vermindert werden kann. Kurzkanaleffekte und Punchthrough des Transistors 110 und des parasitären Vertikaltransistors sind somit vermeidbar.

Die Kombination einer hinreichend dicken Tunnelschicht 205 an der Grenzfläche 201 zur Verhinderung der Ausdiffusion der leitenden vergrabenen Brücke 162 und der Versetzungsbildung an der leitenden vergrabenen Brücke 162 in Kombination mit einer flachen Implantation bilden einen besonders guten vergrabenen Kontakt 250 zwischen dem Transistor 110 und dem Grabenkondensator 160.

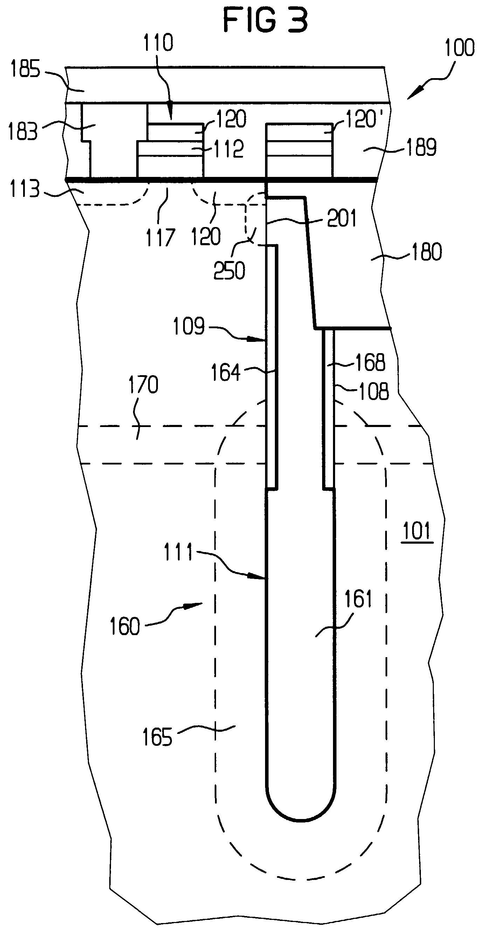

Fig. 3 zeigt ein weiteres Ausführungsbeispiel einer DRAM-Speicherzelle gemäß der vorliegenden Erfindung entsprechend einer zweiten Ausführungsform des erfindungsgemäßen Verfahrens.

Wie in Fig. 3 illustriert, baut die zweite Ausführungsform auf die in Figur 10 gezeigte bekannte Variante auf, wobei ebenfalls wie bei der ersten Ausführungsform der vergrabene Kontakt 250 anstelle von Diffusion durch Implantation, Plasmadotierung und/oder Gasphasendotierung hergestellt wird.

Fig. 4a,b zeigen die zweite Ausführungsform des erfindungsgemäßen Verfahrens zur Herstellung der DRAM-Speicherzelle nach Fig. 3.

Mit Bezug auf Fig. 4a, welche dem in Figur 11c gezeigten Prozeßstadium entspricht, wird eine schräge Implantation durchgeführt, wie in Zusammenhang mit der ersten Ausführungsform beschrieben. Anschließend erfolgt, wie in Fig. 4b gezeigt, die Bildung mit der leitenden Grabenfüllung 161 und das Einsenken der leitenden Grabenfüllung 161 auf ca. 50 nm unterhalb der Substratoberfläche.

Die weiteren Verfahrensschritte verlaufen so, wie in Zusammenhang mit Figur 7g beschrieben.

In diesem Zusammenhang sei weiterhin noch erwähnt, daß die erste und zweite Ausführungsform auch bei einem Grabenkondensator anwendbar sind, welcher herstellungsgemäß eine weitere Grenzfläche 202 zwischen dem unteren Teil 111 des Grabens 108 und dem oberen Teil 109 des Grabens 108 aufweist, nämlich an der Unterseite des Isolationskragens 168 (vgl. Fig. 9).

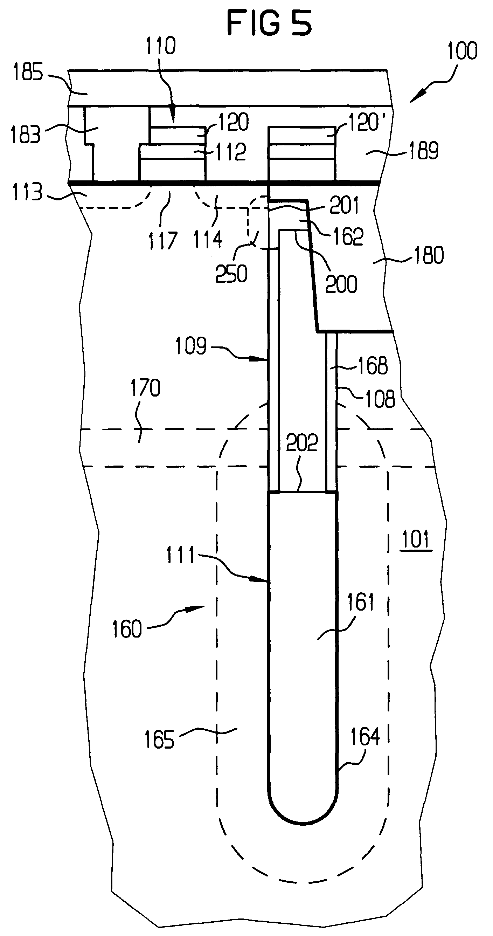

Eine solche Struktur ist in Fig. 5 gezeigt, die ein weiteres Ausführungsbeispiel einer DRAM-Speicherzelle gemäß der vorliegenden Erfindung entsprechend einer dritten Ausführungsform des erfindungsgemäßen Verfahrens illustriert.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere sind die angeführten Materialien nur beispielhaft und durch andere Materialien mit geeigneten Eigenschaften ersetzbar. Das Gleiche gilt für die genannten Reinigungs- und Dotier-, thermischen Aufwachs- und/oder Abscheidungsprozesse.

Obwohl für die Tunnelschicht 205 insbesondere eine Oxid-, Nitrid- oder Oxynitrid-Schicht genannt wurden, ist prinzipiell jede Schicht geeignet, die während der thermischen Prozeßschritte von typischerweise 1100 °C nicht aufbricht und einen möglichst hohen Tunnelstrom erlaubt.

Auch sind die gezeigten Ausführungsformen miteinander kombinierbar, was die Abfolge der Prozeßschritte betrifft.

## Patentansprüche

1. Grabenkondensator:
- mit einem Graben (108), der in einem Substrat (101) gebildet ist und einen oberen Bereich (109) und einen unteren Bereich (111) aufweist;
- mit einem Isolationskragen (168) der in dem oberen Bereich (109) des Grabens (108) gebildet ist;
- mit einer vergrabenen Wanne (170), die in dem Substrat (101) gebildet ist und die von dem unteren Bereich (111) des Grabens (108) zumindest teilweise durchsetzt ist;
- mit einer vergrabenen Platte (165) als äußere Kondensatorelektrode, die um den unteren Bereich (111) des Grabens (108) gebildet ist;
- mit einer dielektrischen Schicht (164) als Kondensatordielektrikum, zur Verkleidung des unteren Bereichs (111) des Grabens (108) und des Isolationskragens (168)
- und mit einer leitenden Grabenfüllung (161), welche in den Graben (108) gefüllt ist,
**dadurch gekennzeichnet,**
daß das Substrat (101) einen durch Implantation, Plasmadotierung und/oder Gasphasendotierung eingebrachten vergrabenen Kontakt (250) aufweist.

2. Grabenkondensator nach Anspruch 1,
**dadurch gekennzeichnet,**
daß sich in dem Graben (108) oberhalb der leitenden Grabenfüllung (161) eine leitende vergrabene Brücke (162) befindet.

3. Grabenkondensator nach Anspruch 1 oder 2,
**dadurch gekennzeichnet,**
daß der Graben (108) eine flaschenartige Form aufweist und in einem verbreiterten Bereich der flaschenartigen Form des Grabens (108) ein Hohlraum (172) in der leitenden Grabenfüllung (161) ausgebildet ist.

4. Kondensator nach einem der Ansprüche 1 bis 3,
**dadurch gekennzeichnet,**
daß die leitende vergrabene Brücke (162) eine Verbindung zwischen der leitenden Grabenfüllung (161) und dem vergrabenen Kontakt (250) bildet.

5. Grabenkondensator nach einem der Ansprüche 1 bis 4,
**dadurch gekennzeichnet,**
daß an einer Grenzfläche (201) des vergrabenen Kontakts (250) eine Tunnelschicht (205) angeordnet ist.

6. Grabenkondensator nach einem der Ansprüche 1 bis 5,
**dadurch gekennzeichnet,**
daß die Tunnelschicht (205) aus Oxid, Nitrid oder Oxynitrid besteht.

7. Grabenkondensator nach einem der Ansprüche 1 bis 6,
**dadurch gekennzeichnet,**
daß der Grabenkondensator über einen vergrabenen Kontakt (250) mit einem Transistor (110) verbunden ist.

8. Verfahren zur Herstellung eines Grabenkondensators mit den Schritten:
- Einbringen einer vergrabenen Wanne (170) in ein Substrat (101);
- Bilden eines Grabens (108) bestehend aus einem oberen Bereich (109) und einem unteren Bereich (111) in dem Substrat (101),
- Bilden eines Isolationskragens (168) in dem oberen Bereich (109) des Grabens (108);
- Bilden einer vergrabenen Platte (165) als äußere Kondensatorelektrode, in dem Substrat (101) in der Umgebung des unteren Bereichs (111) des Grabens (108);
- Bilden einer dielektrischen Schicht (164) als Kondensatordielektrikum zur Verkleidung des unteren Bereichs (111) des Grabens (108) und der Innenseite des Isolationskragens (168) und
- Füllen des Grabens (108) mit einer leitenden Grabenfüllung (161) als innere Kondensatorelektrode,
**gekennzeichnet durch**
Bilden eines vergrabenen Kontakts (250) durch Einbringen von Dotierstoff mittels Implantation, Plasmadotierung und/oder Gasphasendotierung.

9. Verfahren nach Anspruch 8,
**dadurch gekennzeichnet,**
daß der Dotierstoff zur Bildung des vergrabenen Kontakts (250) mittels schräger oder isotroper Implantation durch eine freigelegte oder mit einem Streuoxid versehene Grenzfläche (201) eingebracht wird.

10. Verfahren nach Anspruch 8,
**dadurch gekennzeichnet,**
daß der Dotierstoff zur Bildung des vergrabenen Kontakts (250) mittels einer Gasphasendotierung durch eine Grenzfläche (201) eingebracht wird.

11. Verfahren nach Anspruch 10,
**dadurch gekennzeichnet,**
daß die Gasphasendotierung bei Temperaturen zwischen 800° und 1200° C und Drücken zwischen 500 Pa und 50 kPa durchgeführt wird.

12. Verfahren nach einem der Ansprüche 9 bis 11,
**dadurch gekennzeichnet,**
daß an der Grenzfläche (201) des vergrabenen Kontakts (250) eine Tunnelschicht (205) gebildet wird.

13. Verfahren nach Anspruch 12,
**dadurch gekennzeichnet,**
daß die Tunnelschicht (205) aus Oxid, Nitrid und/oder Oxynitrid gebildet wird.

14. Verfahren nach einem der Ansprüche 8 bis 13,
**gekennzeichnet durch**
Bilden einer leitenden vergrabenen Brücke (162) auf der leitenden Grabenfüllung (161).

15. Verfahren nach einem der Ansprüche 8 bis 14,
**gekennzeichnet durch**
Erweitern des unteren Bereichs (111) des Grabens (108) gegenüber dem oberen Bereich (109) des Grabens (108) zum Bilden einer flaschenartigen Form.

16. Verfahren nach einem der Ansprüche 14 oder 15,
**dadurch gekennzeichnet,**
daß der vergrabene Kontakt (250), die Tunnelschicht (205) und die leitende vergrabene Brücke (162) in einer Prozeßabfolge, ohne zwischenzeitliches Entnehmen des Substrats (101) aus einer Prozeßkammer, durchgeführt wird.
